(19) Europäisches Patentamt
European Patent Office
Office européen des brevets

(11) EP 4 252 285 B1

(12) **EUROPEAN PATENT SPECIFICATION**

(45) Date of publication and mention of the grant of the patent:
**11.02.2026 Bulletin 2026/07**

(21) Application number: **21820676.1**

(22) Date of filing: **30.11.2021**

(51) International Patent Classification (IPC):
***H10F 77/20*** *(2025.01)* ***H01B 1/08*** *(2006.01)*
***H10F 71/00*** *(2025.01)*

(52) Cooperative Patent Classification (CPC):
**H10F 77/244; H01B 1/08; H10F 71/138;**
H10H 20/833; H10K 30/82; H10K 2102/101

(86) International application number:
**PCT/GB2021/053121**

(87) International publication number:
**WO 2022/112802 (02.06.2022 Gazette 2022/22)**

(54) **COMPOSITION OF TRANSPARENT CONDUCTIVE MATERIAL AND METHOD FOR FABRICATING THE SAME**

ZUSAMMENSETZUNG VON DURCHSICHTIGEM LEITFÄHIGEM MATERIAL UND DEREN HERSTELLUNGSVERFAHREN

COMPOSITION DE MATÉRIAU TRANSPARENT CONDUCTEUR ET MÉTHODE POUR SA FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.11.2020 GB 202018825**

(43) Date of publication of application:
**04.10.2023 Bulletin 2023/40**

(73) Proprietor: **The University of Liverpool**
**Liverpool, Merseyside L69 7ZX (GB)**

(72) Inventors:
- **STONER, Jessica**
  **Liverpool Foundation Building 765 Brownlow Hill**
  **Liverpool Merseyside L69 7ZX (GB)**
- **ALARIA, Jonathon**
  **Liverpool Foundation Building 765 Brownlow Hill**
  **Liverpool Merseyside L69 7ZX (GB)**
- **ROSSEINSKY, Matthew**
  **Liverpool Foundation Building 765 Brownlow Hill**
  **Liverpool Merseyside L69 7ZX (GB)**

(74) Representative: **Appleyard Lees IP LLP**
**15 Clare Road**
**Halifax HX1 2HY (GB)**

(56) References cited:
**WO-A1-2016/019327**

- **STONER JESSICA L. ET AL: "Chemical Control of Correlated Metals as Transparent Conductors", vol. 29, no. 11, 25 January 2019 (2019-01-25), DE, pages 1808609, XP055832328, ISSN: 1616-301X, Retrieved from the Internet <URL:https://api.wiley.com/onlinelibrary/tdm/v1/articles/10.1002%2Fadfm.201808609> [retrieved on 20210816], DOI: 10.1002/adfm.201808609**
- **DANIEL E MCNALLY ET AL: "Electronic Localization in CaVO3 Films via Bandwidth Control", ARXIV.ORG, CORNELL UNIVERSITY LIBRARY, 201 OLIN LIBRARY CORNELL UNIVERSITY ITHACA, NY 14853, 28 August 2019 (2019-08-28), XP081471265, DOI: 10.1038/S41535-019-0146-3**
- **STEVEN R SPURGEON: "Order-Disorder Behavior at Thin Film Oxide Interfaces", ARXIV.ORG, CORNELL UNIVERSITY LIBRARY, 201 OLIN LIBRARY CORNELL UNIVERSITY ITHACA, NY 14853, 30 July 2020 (2020-07-30), XP081729364**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 252 285 B1

- WILLMOTT P R ET AL: "Structural basis for the conducting interface between LaAlO3 and SrTiO3", PHYSICAL REVIEW LETTERS, 12 October 2007 (2007-10-12), United States, pages 155502 - 01, XP055831506, Retrieved from the Internet <URL:https://journals.aps.org/prl/pdf/10.1103/PhysRevLett.99.155502> [retrieved on 20210811], DOI: 10.1103/PhysRevLett.99.155502
- MARTINA ZUPANCIC ET AL: "The role of the interface in controlling the epitaxial relationship between orthorhombic textLaInO_text3 and cubic textBaSnO_text3", ARXIV.ORG, CORNELL UNIVERSITY LIBRARY, 201 OLIN LIBRARY CORNELL UNIVERSITY ITHACA, NY 14853, 21 August 2020 (2020-08-21), XP081745627

## Description

### Field

The present invention relates to transparent conducting materials.

### Background to the invention

Oxide interfaces have shown a wealth of emergent phenomena, presenting remarkable physics beyond conventional semiconductors. Electronic reconstruction at a carefully engineered interface and confined polarisation, spin, and orbital degrees of freedom can lead to properties not observed in the isolated bulk materials. Notable examples include the combination of $LaMnO_3$ and $SrMnO_3$, both antiferromagnetic insulators, exhibiting double-exchange ferromagnetism at their interface, and the quantum hall effect in a high-mobility electron gas between ZnO and $Zn_{1-x}Mg_xO$. A further key example is the $LaAlO_3/SrTiO_3$ (LAO/STO) interface. The LAO/STO interface has been widely studied and exhibits functional phenomena such as gate-tuneable superconductivity and ferromagnetism. When brought together, the ionic polar discontinuity generates a shift in electronic charge resulting in the formation of a high mobility 2D electron gas. Analogous to the way semiconductors are chemically doped, this provides intrinsic carrier doping without the structural disorder added by chemical dopants. This charge transfer effect is also predicted to arise between a metal and a band insulator, provided the band edges of the candidate materials are suitably aligned. Although widely studied, these interfacial properties are difficult to harness into application. LAO/STO heterostructures are made with precise techniques, requiring specific substrate termination and an exact number of unit cells to observe the effect. This kind of carefully controlled growth is time-consuming, and controlled substrate termination requires chemical etching, often with toxic chemicals such as hydrofluoric acid (HF). Moreover, the high mobility carriers are localised at the interface within a few unit cells and is difficult to access.

High-performance, transparent conducting materials (TCMs), for example transparent conducting oxides (TCOs), are in high demand due to their widespread application in display screen technologies and photovoltaics. Whereas heavily doped, wide band gap semiconductors have been the focus of research growth in the past, correlated metals have shown to be a promising alternative. Electronic correlation refers to electrostatic interactions between electrons causing a change in the effective carrier mass. To account for this, the band mass $m^*_{band}$ is renormalized by factor $Z_k$ giving the re-normalised carrier mass, $m^*_r = m^*_{band}/Z_k$. This results in a reduced electrical conductivity, (2),

$$\sigma = \frac{q^2 \cdot \tau \cdot n_{eff}}{m^*}$$

where $\tau$ the scattering time of the carrier.

To identify a candidate transparent conducting material, electrical conductivity and optical transmission are assessed, but due to their antagonistic dependencies, optimal property tuning is challenging. Suitable transparent conducting materials (TCMs) are identified primarily via a high electrical conductivity and a small optical absorption in the visible part of the spectrum (1.75-3.2 eV).

Optical transmission is partially governed by free carrier reflection represented by the screened plasma frequency $\omega_p$ given by:

$$\omega_p = \frac{q}{2\pi \cdot \sqrt{\varepsilon_0 \varepsilon_r}} \cdot \sqrt{\frac{n_{eff}}{m^*}}$$

where $q$ is the electrical charge, $\varepsilon_0$ the permittivity of space, $\varepsilon_r$ the relative permittivity of the compound (also known as dielectric constant), $n_{eff}$ the effective carrier concentration and m* the effective mass of the carrier. Due to the large intrinsic carrier density in conventional metals, the free carrier reflection is generally within or above the visible spectrum. In correlated metals, the plasma frequency is reduced to the near infrared via increased effective mass minimising the impact on visible light transmission despite the large metallic carrier density.

Interband transitions define light absorption in a material and therefore are also a key controllable parameter for optical transmission. The energy of interband transitions are determined intrinsically by the B-site transition metal frontier orbital energies and can be identified experimentally in the complex dielectric function.

Due to the large intrinsic carrier density in conventional metals, the free carrier reflection is generally within or above the visible spectrum. In correlated metals, the plasma frequency can be reduced to the near infrared via increased effective mass minimising the impact on visible light transmission despite a large metallic carrier density.

Transparent conducting oxides (TCOs) are the current front-running commercial materials with tin-doped indium oxide (ITO) and fluorine-doped tin oxide (FTO) being the most widely used. These compounds are wide bandgap (>3 eV) semiconductor oxides with no intraband transition in the visible spectrum, therefore offering high transparency. A high level of doping shifts the Fermi level into the conduction band to provide metallic-like electrical conduction, with the free carrier reflection edge (represented by the screened plasma frequency $\omega_p$) below the near-infrared region of the spectrum (<1.75 eV). In these classical degenerately doped semiconductor TCOs, there is direct competition between screened plasma frequency $\omega_p$ and the electrical conductivity $\sigma$, which are both controlled by the effective carrier concentration $n_{eff}$ and the effective mass $m^*$ of the carrier, but in antagonistic ways. This competition governs the optimization of the effective carrier concentration $n_{eff}$ and the effective mass m* of the carrier in wide bandgap TCOs, where increase in carrier density and a reduction of effective mass is pursued to maximize conductivity, at the cost of increasing the plasma frequency while simultaneously reducing transparency in the visible. The overall performance of the TCO is quantified by the Haacke figure of merit (FOM), $\Phi_{TC} = T^{10}/R_s$, where $T$ is the average transmission in the visible and $R_s$ is the sheet resistance. In practice, the maximum attainable conductivity in semiconductors is fundamentally limited, as increasing dopant concentration to raise the number of carriers decreases carrier mobility due to ionized impurity scattering and grain boundaries. Other practical limitations of doped semiconductor TCOs include low solubility limit of the dopant, toxicity of common dopants such as fluorine in FTO (with the use of hydrofluoric acid (HF) in the production process) and the scarcity of In increasing the cost of ITO. The current alternative to TCO materials is a very thin layer of a conventional metal such as Ag. In this case the overall performance of the material as a TCM is limited by the large electron mean free path of conventional metals (~50 nm) increasing the interfacial scattering and therefore reducing the coating conductivity.

The intrinsic limit to enhance conventional semiconductors through chemical doping is well known. However, like traditional semiconductors, correlated metals also appear to reach an intrinsic limit to the tunability of their properties, with reports showing the Haacke figure of merit reaching a maximum of $3.4 \times 10^{-3}\ \Omega^{-1}$. Some enhancement can be gained from selection of the electronic configuration, B-site cation and band- width tuning, but the high carrier density and increased effective mass limit further tuning via these controls.

STONER, JESSICA L. ET AL: "Chemical Control of Correlated Metals as Transparent Conductors", ADVANCED FUNCTIONAL MATERIALS, vol. 29, no. 11, 25 January 2019, page 1808609 describes chemical control of correlated metals as transparent conductors. DANIEL E MCNALLY ET AL: "Electronic Localization in CaVO3 Films via Bandwidth Control", ARXIV.ORG, CORNELL UNIVERSITY LIBRARY, 201 OLIN LIBRARY CORNELL UNIVERSITY ITHACA, NY 14853, 28 August 2019 describes electronic localization in $CaVO_3$ films via bandwidth control. STEVEN R SPURGEON: "Order-Disorder Behavior at Thin Film Oxide Interfaces" ARXIV.ORG, CORNELL UNIVERSITY LIBRARY, 201 OLIN LIBRARY CORNELL UNIVERSITY ITHACA, NY 14853, 30 July 2020 describes order-disorder behavior at thin film oxide interfaces. WO 2016/019327 A1 describes transparent conducting films.

Hence, there is a need to improve transparent conducting materials.

## Summary of the Invention

It is one aim of the present invention, amongst others, to provide a transparent conducting material which at least partially obviates or mitigates at least some of the disadvantages of the prior art, whether identified herein or elsewhere. For instance, it is an aim of embodiments of the invention to provide a transparent conducting material having an improved Haacke figure of merit.

The transparent conducting film of the invention is defined in the appended claim 1. It corresponds to a first aspect in which $SrNbO_3$ and $SrTiO_3$ are chosen as first and third layers respectively.

An electrode according to claim 8 comprising the transparent conducting film of claim 1 corresponds to a second aspect. A method of providing the transparent conducting film of claim 1 corresponds to a third aspect.

## Detailed Description of the Invention

According to the present invention there is provided a film, as set forth in the appended claims. Also provided is an electrode comprising such a film and a method of providing such a film. Other features of the invention will be apparent from the dependent claims, and the description that follows.

### *Film*

The first aspect provides a film comprising a set of layers including a first layer, a third layer and a second layer therebetween;

wherein the first layer comprises and/or is a transparent conductive oxide having a formula:

$A^1 B^1 O_{3-\delta_1}$;

wherein the third layer comprises and/or is a transparent wide-bandgap semiconductor oxide having a formula:

$A^3 B^3 O_{3-\delta_3}$;

wherein the second layer comprises and/or is an oxide having a formula:

$$A^1_\alpha A^3_{1-\alpha} B^1\ O_{3-\delta_2} \text{ or } A^1_\alpha A^3_{1-\alpha} B^3\ O_{3-\delta_2} \text{ or } A^3\ B^1_\beta B^3_{1-\beta} O_{3-\delta_2} \text{ or } A^1_\alpha A^3_{1-\alpha} B^1_\beta B^3_{1-\beta} O_{3-\delta_2};$$

wherein $0 < \alpha, \beta < 1$, $-0.5 \leq \delta_1, \delta_2, \delta_3 \leq 0.5$.

By combining the mass enhancement gained through electron correlation with the possibility of increasing the conductivity with light, high mobility carriers, a new design parameter to optimise these transparent conducting materials has been identified by the inventors. Particularly, the inventors have demonstrated that intrinsic charge transfer in the second layer (also known as an interface layer), for example $SrNbO_3/SrTiO_3$ (SNO/STO) interface, may be harnessed to enhance electronic conductivity in transparent correlated metal perovskite oxide interfaces and out-perform other correlated metal TCOs and traditional wide-gap semiconductors.

One of the advantages of the film is that by having a conductive first layer (for example, SNO), it is possible to easily extract/make use of the highly mobile electrons in the second (interface) layer while maintaining the high transparency. It might be possible to replicate the highly mobile second layer using as insulating oxide as the second layer e.g. $Nb_2O_5$ or $NbO_2$ but it would be very difficult to extract the electrons from the second layer.

In other words, the third layer comprises and/or is the transparent wide-bandgap semiconductor oxide that is capable of being doped to provide high mobility carriers, for example STO or $BaSnO_3$, the first layer comprises and/or is the TCO or correlated metal that includes a suitable dopant for the transparent wide-bandgap semiconductor oxide of the third layer, for example SNO for STO and $LaNiO_3$ for $BaSnO_3$, whereby the oxide of the second or interface layer, for example formed by diffusion of dopant from the first layer to the third layer, has active high carrier mobility, thus providing an active high mobility layer. The oxide of the second layer may be compositionally homogeneous or may include a compositional gradient, as described below. The second layer is also sufficiently thin enough that its optical absorption is low (for example, having a thickness in a range from 0.5 to 50 nm) but may be difficult to form as a conventional thin layer, for example in isolation. The TCO of the first layer, being a conductor, extracts and uses the active high mobility carriers of the second layer.

For example, for SNO (the TCO of the first layer) on STO (the transparent wide-bandgap semiconductor of the third layer), Nb doping from the SNO into the STO forms the doped $Sr(Nb,Ti)O_3$ oxide of the second layer.

For example, for $LaNiO_3$ (the TCO of the first layer) on $BaSnO_3$ (the transparent wide-bandgap semiconductor of the third layer), La doping from the $LaNiO_3$ into the $BaSnO_3$ forms the doped $(La,Ba)SnO_3$ oxide of the second layer.

In contrast, SNO on $BaSnO_3$ is unlikely to work since Sr or Nb are not suitable dopants for Ba or Sn respectively in $BaSnO_3$.

In particular, generating charge transfer between two insulators may result in a high mobility 2D electron gas (2DEG). This effect is predicted to arise between a metal and an insulator if band alignment is correct: for example, at the $SrNbO_3/SrTiO_3$ interface.

More generally, the first aspect provides a transparent conducting material that may be provided as a film, amongst other forms.

Oxide interfaces have shown a wealth of emergent phenomena, presenting remarkable physics beyond conventional semiconductors. Electronic reconstruction at a carefully engineered interface and confined polarisation, spin, and orbital degrees of freedom can lead to properties not observed in the isolated bulk materials. Notable examples include the combination of $LaMnO_3$ and $SrMnO_3$, both antiferromagnetic insulators, exhibiting double-exchange ferromagnetism at their interface, and the quantum Hall effect in a high-mobility electron gas between $ZnO/Zn_{1-x}Mg_xO$. A further key example is the $LaAlO_3/SrTiO_3$ (LAO/STO) interface. The LAO/STO interface has been widely studied and exhibits interesting functional phenomena such as gate-tuneable superconductivity and ferromagnetism. When brought together, the ionic polar discontinuity generates a shift in electronic charge resulting in the formation of a high mobility 2D electron gas. Analogous to the way semiconductors are chemically doped, this provides intrinsic carrier doping without the structural disorder added by chemical dopants.

Correlated metals have been shown to be potential candidate TCMs. Combining the mass enhancement with the possibility of increasing the carrier concentration with high mobility carrier adds a new design parameter to optimise these materials but would require an abrupt interface and the large difference in carrier concentration between the 2DEG and the correlated metal would generate an electrostatic barrier to inject the highly mobile carrier in the metal.

In more detail, STO is a semiconductor with 3.2eV band gap and can be doped n or p- type. Hydrogenic theory of shallow donors can be applied to STO with some caveats but qualitatively comparable to experimental results. STO exhibits unusual dielectric properties - the dielectric constant is strongly temperature dependant and high. For example, the dielectric constant $\varepsilon_r$ of STO is about 300 at 300K but tens of thousands at lower temperatures. The dielectric response is used to interpret unexpectedly high mobility at low temperatures of STO. For example, n- type conduction may be achieved by substituting $La^{3+}$ for $Sr^{2+}$, $Nb^{5+}$ for $Ti^{4+}$ or by reduction of $SrTiO_{3-\delta}$, where in a simple picture, each O vacancy generates two doped electrons. Thus, STO exhibits a high-mobility metallic state with strongly temperature-dependent resistivity, which persists down to the lowest carrier-densities probed, in the absence of carrier freeze out. Most highly reduced STO (reduced at a temperature of 1100 °C) had resistivity of 2.71 Ω.cm at 300K and residual resistance ratio (RRR) of 2710 and estimated carrier concentration of $10^{17}$ $m^{-3}$. Nb doping may typically be from 0.02 at.% to 2.0 at.%.

The correlated metal $SrNbO_3$ exhibits excellent performance in the visible and the UV regime from 260 to 320 nm. This UV transparent conductor uses the energetically isolated conduction band originating from the Nb 4d orbitals and a sizeable electron correlation present in $SrNbO_3$ (c.f. vanadates in the visible spectrum). Many body effects arising from strong electron-electron interactions affect transport properties and optical response of the carriers in correlated metals and are quantified by the renormalization constant $Z_k$. If the electron interaction strength is negligible $Z_k = 1$ and itinerant carriers respond like a free electron gas. Conversely, if $Z_k = 0$, as a consequence of a strong electron interaction, all free carriers are localized at lattice sites (Mott insulator). Alternatively, if the renormalization constant is $0 < Z_k < 1$, electrons maintain their itinerant character but their dynamic properties, such as the carrier mass $m^*$, are renormalized, as described previously. For correlated metals, the renormalized carrier mass $m_r^*$ is increased relative to the band effective mass $m_{band}^*$ by the inverse of the renormalization constant $Z_k$. Hence, the reduced plasma frequency $\omega_p$ shifts towards the IR despite a metal-like carrier concentration $n_{eff}$. Although the increase in effective mass $m_{band}^*$ reduces partly the electrical conductivity $\sigma$, typical electrical conductivities of correlated metals have been found to be about one order of magnitude higher than that of ITO and more than three orders of magnitude higher than those of doped $\beta$-$Ga_2O_3$ and $ZnGa_2O_4$. However, while correlated oxides having perovskite structures have been demonstrated to behave as conventional transparent conductors, significant losses to optical transparency in the visible range arise to the location of their absorption edges. For example, for $SrVO_3$, the absorption edge is located at about 2.9 eV (427 nm), with the large absorption arising from an interband transition from oxygen 2p bands forming the valence band to the unoccupied states of the conduction band derived from the t2g orbitals of the transition metal element vanadium. However, this interband absorption edge may be shifted to higher energy if the electronegativity difference $\Delta\chi$ between the transition metal cation and oxygen anion is increased. Hence, by choosing a transition metal, for example, having a larger $\Delta\chi$ with respect to the oxygen anion (i.e. less electronegative compared with vanadium) but a similar electronic configuration, increases the energy difference between O 2p and transition metal t2g bands, causing the absorption edge to be located at higher photon energies. For example, niobium $Nb^{4+}$ is isoelectronic with respect to $V^{4+}$ but has a lower electronegativity (1.690 for $Nb^{4+}$ compared with 1.795 for $V^{4+}$). Hence, by replacing $V^{4+}$ with $Nb^{4+}$, $\Delta\chi$ is increased by about 6%, thereby shifting the interband absorption edge beyond the visible range and into the UV range (i.e. blue shift). Furthermore, by replacing at least some $V^{4+}$ with $Nb^{4+}$, the electron correlation strength is reduced. Particularly, the size of d-orbitals for $Nb^{4+}$ is larger than compared with $V^{4+}$, so that the orbital overlap and thus the bandwidth W of the conduction band is also larger for $SrNbO_3$ compared with $SrVO_3$, despite having a larger lattice parameter $\alpha$ (4.02 Å for $SrNbO_3$ compared with 3.84 Å for $SrVO_3$). By reducing the electron correlation strength, the renormalization constant $Z_k \rightarrow 1$, thereby lowering $m_r^*$ and in turn, decreasing the correlation induced red-shift of the reduced plasma frequency that could otherwise reduce optical transparency of $SrNbO_3$ at long wavelengths of the visible spectrum.

This charge transfer effect is also expected to arise between a metal and a band insulator, provided the band edges of the candidate materials are suitably aligned. Theoretical work by Zhong and Hansmann ( Zhicheng Zhong and Philipp Hansmann, Band Alignment and Charge Transfer in Complex Oxide Interfaces, PHYSICAL REVIEW X 7, 011023 (2017), DOI: 10.1103/PhysRevX.7.011023) predicts the effects of interfacing transition metal-oxides starting from basic laws defined for semiconductors. In a simple case of two ideal cubic perovskites, $ABO_3$ and $AB'O_3$ forming a hetero-structure, a smooth structural transition and a shared oxygen matrix imply the boundary condition that oxygen states are continuous across the boundary. For materials with different local oxygen energy levels, this would result in a mismatch of Fermi energy $E_F$. Since $E_F$ must be constant throughout a heterostructure in equilibrium, a transfer of charge occurs between the materials. The direction and strength of the charge transfer is determined by the difference in the bulk oxygen 2*p* energies with respect to their Fermi level. DFT studies of a variety of bulk compounds predicts the strength and size of the charge transfer in a single interface and in layered heterostructures. Although counterintuitive, charge transfer would not occur from the partially filled $3d^1$ $SrVO_3$ to the empty d states of $SrTiO_3$ (STO), due to the higher energy of the oxygen states in the latter. However, the lower energy oxygen states in $4d^1$ compounds $SrNbO_3$ (SNO) compared with STO, allow for a substantial electron transfer from the Nb 4d to the Ti 3d states. This allows for controlled electron doping via charge transfer of one of the most widely used transition metal oxides, inducing accessible high mobility electronic conduction.

*Film*

The film comprises the set of layers including the first layer, the third layer and the second layer therebetween. It should be understood that the second layer comprises and/or is an interface layer, disposed at the interface between the first layer and the third layer.

It should be understood that $A^1$, $A^3$, $B^1$ and $B^3$ are different from each other and deviations from ideal oxygen stoichiometry are given by $\delta_1$, $\delta_2$, $\delta_3$. It should be understood that $A^1$, $A^3$, $B^1$ and $B^3$ may respectively represent one or more cations.

*First layer*

The first layer comprises and/or is the transparent conductive oxide (TCO) (also known as a transparent correlated metal or a correlated metal) having the formula:

$$A^1 B^1 O_{3-\delta_1}.$$

TCOs are known. See, for example, Y. Tokura Correlated-Electron Physics in Transition-Metal Oxides, Physics Today, 2003, 56, 50 (https://doi.org/10.1063/1.1603080).

In one example the first layer has the formula:

$$A^{1,1}_{1-x}A^{1,2}_{x}B^{1,1}_{1-y}B^{1,2}_{y}O_{3-\delta_1} \text{ or } \left(A^{1,1}B^{1,1}O_{3-\delta_{1,1}}\right)_j \left(A^{1,2}B^{1,2}O_{3-\delta_{1,2}}\right)_k;$$

wherein $0 < x, y < 1$, $-0.5 \leq \delta_1$, $(\delta_{1,1} + \delta_{1,2}) \leq 0.5$ and $j, k$ account for the thickness of individual nano-laminates in units of the perovskite unit cell, for example $1 \leq j, k \leq 10$, for a TCO having such a laminated structure. It should be understood that $A^{1,1}$, $A^{1,2}$, $B^{1,1}$ and $B^{1,2}$ are different from each other and deviations from ideal oxygen stoichiometry are given by $\delta_1$, $\delta_{1,1}$, $\delta_{1,2}$. Generally, this notation is applied similarly, mutatis mutandis.

Generally, $A^1$ represents one or more divalent alkaline earth cations, one or more trivalent cations and/or one or more monovalent cations. In one example, $A^1$ is selected from Group 2 (Be, Mg, Ca, Sr, Ba, Ra; preferably Ca, Sr, Ba) and/or the Lanthanides (La, Ce, Pr, Nd, Pm, Sm, Eu, Gd, Tb, Dy, Ho, Er, Tm, Yb, Lu; preferably La, Pr, Nd). In one example, $A^1$ is one or more divalent alkaline earth cations selected from Ca, Sr, Ba, preferably Sr. $A^{1,1}$ and/or $A^{1,2}$ may be as described with respect to $A^1$.

Generally, $B^1$ represents a transition metal selected from Group 5, Group 6, Group 10 and/or Group 4 and/or a metal selected from Group 14 and/or Group 13. In one example, $B^1$ is selected from Group 5 (V, Nb, Ta, Db; preferably V, Nb, Ta), Group 6 (Cr, Mo, W, Sg; preferably Cr, Mo, W) and/or Group 10 (Ni, Pd, Pt, Ds; preferably Ni). In one example, $B^1$ is one or more transition metal cations selected from V, Nb, preferably Nb. $B^{1,1}$ and/or $B^{1,2}$ may be as described with respect to $B^1$.

In one example, $A^1$ and $B^1$ are according to Table 1.

Table 1: $A^1$ and $B^1$.

| $A^1$ | $B^1$ |
|---|---|
| Ca | V |
| Ca | Nb |
| Ca | Ta |
| Ca | Cr |
| Ca | Mo |
| Ca | W |
| Ca | Ni |
| Sr | V |
| Sr | Nb |
| Sr | Ta |
| Sr | Cr |

(continued)

| $A^1$ | $B^1$ |
|---|---|
| Sr | Mo |
| Sr | W |
| Sr | Ni |
| Ba | V |
| Ba | Nb |
| Ba | Ta |
| Ba | Cr |
| Ba | Mo |
| Ba | W |
| Ba | Ni |
| La | V |
| La | Nb |
| La | Ta |
| La | Cr |
| La | Mo |
| La | W |
| La | Ni |
| Pr | V |
| Pr | Nb |
| Pr | Ta |
| Pr | Cr |
| Pr | Mo |
| Pr | W |
| Pr | Ni |
| Nd | V |
| Nd | Nb |
| Nd | Ta |
| Nd | Cr |
| Nd | Mo |
| Nd | W |
| Nd | Ni |

In one example, the first layer has an electron mobility in a range from 1 to 100 $cm^2V^{-1}s^{-1}$, a carrier density in a range from $1 \times 10^{20}$ to $1 \times 10^{24}$ $cm^{-3}$, a transmittance in a range from 75% to 100% at a wavelength of 550 nm, a thickness in a range from 2 to 100 nm, an effective mass in a range from 1 to 10 $m_0$ and/or a conductivity in a range from 1,000 to 100,000 $Scm^{-1}$ at room temperature.

*Third layer*

The third layer comprises and/or is the transparent wide-bandgap semiconductor oxide having the formula:

$$A^3 B^3 O_{3-\delta_3}.$$

Transparent wide-bandgap semiconductor oxides are known. See, for example, Wide Bandgap Perovskite Oxides with High Room-Temperature Electron Mobility, Abhinav Prakash and Bharat Jalan, 6 July 2019, Advanced Material Interfaces, 2019, 6, 1900479, https://doi.org/10.1002/admi.201900479.

In one example, $A^3$ and/or is $B^3$ is selected for adjusting a Fermi level position in a conduction band of the TCO of the first layer.

In one example, the transparent wide-bandgap semiconductor oxide has the formula:

$$A^{3,1}_{1-u}A^{3,2}_{u}B^{3,1}_{1-v}B^{3,2}_{v}O_{3-\delta_3} \text{ or } \left(A^{3,1}B^{3,1}O_{3-\delta_{3,1}}\right)_m \left(A^{3,2}B^{3,2}O_{3-\delta_{3,2}}\right)_n;$$

wherein $0 < u, v < 1$, $-0.5 \leq \delta_3, (\delta_{3,1} + \delta_{3,2}) \leq 0.5$ and $m$, $n$ account for the thickness of individual nano-laminates in units of the perovskite unit cell, for example $1 \leq m, n \leq 10$, for a transparent wide-bandgap semiconductor oxide having such a laminated structure. It should be understood that $A^{3,1}$, $A^{3,2}$, $B^{3,1}$ and $B^{3,2}$ are different from each other and deviations from ideal oxygen stoichiometry are given by $\delta_3$, $\delta_{3,1}$, $\delta_{3,2}$. Generally, this notation is applied similarly, mutatis mutandis.

In one example, $A^3$ is selected from Group 2 (Be, Mg, Ca, Sr, Ba, Ra; preferably Ca, Sr, Ba), Group 12 (Zn, Cd, Hg, Cn; preferably Zn, Cd) and/or the Lanthanides (La, Ce, Pr, Nd, Pm, Sm, Eu, Gd, Tb, Dy, Ho, Er, Tm, Yb, Lu; preferably La, Pr, Nd). In one example, $A^3$ is one or more divalent alkaline earth cations selected from Ca, Sr, Ba, preferably Sr or Ba. $A^{3,1}$ and/or $A^{3,2}$ may be as described with respect to $A^3$ .

In one example, $B^3$ is selected from Group 4 (Ti, Zr, Hf, Rf; preferably Ti) and/or Group 14 (C, Si, Ge, Sn, Pb, UUq; preferably Sn). In one example, $B^3$ is one or more transition metal cations selected from Ti, Zr, preferably Ti; and/or wherein $B^4$ is one or more metal cations selected from Sn. $B^{3,1}$ and/or $B^{3,2}$ may be as described with respect to $B^3$ .

In one example, $A^3$ and $B^3$ are according to Table 2.

Table 2: $A^3$ and $B^3$ .

| $A^3$ | $B^3$ |
|---|---|
| Ca | Ti |
| Ca | Sn |
| Sr | Ti |
| Sr | Sn |
| Ba | Ti |
| Ba | Sn |
| Zn | Ti |
| Zn | Sn |
| Cd | Ti |
| Cd | Sn |
| La | Ti |
| La | Sn |
| Pr | Ti |
| Pr | Sn |
| Nd | Ti |
| Nd | Sn |

In one example,$A^3$ is one or more alkali metal cations selected from group 1 and/or one or more trivalent lanthanide cations and/or $A^3$ is one or more alkali metal cations selected from group 1 and/or one or more trivalent lanthanide cations), for adjusting a Fermi level position in a conduction band of the TCO of the first layer.

In one example, $B^3$ is one or more transition metal cations selected from Groups 4, 6 and/or one or more metal cations selected from Groups 13, 14 and/or $B^3$ is one or more transition metal cations selected from Groups 4, 6 and/or one or more metal cations selected from groups 13, 14, for adjusting a Fermi level position in a conduction band of the TCO of the first layer.

*Second layer*

The second layer comprises and/or is the oxide layer having the formula:

$$A^1_\alpha A^3_{1-\alpha} B^1 O_{3-\delta_2} \text{ or } A^1_\alpha A^3_{1-\alpha} B^3 O_{3-\delta_2} \text{ or } A^3 B^1_\beta B^3_{1-\beta} O_{3-\delta_2} \text{ or } A^1_\alpha A^3_{1-\alpha} B^1_\beta B^3_{1-\beta} O_{3-\delta_2};$$

wherein $0 < \alpha, \beta < 1$, $-0.5 \leq \delta_1, \delta_2, \delta_3 \leq 0.5$.

If the formula is $A^1_\alpha A^3_{1-\alpha} B^1 O_{3-\delta_2}$, $A^1$ site substitution of the TCO of the first layer by $A^3$ is present. Examples of such $A^1$ site substitution include where the transparent wide-bandgap semiconductor oxide is $SrTiO_3$ or a stannate such as $BaSnO_3$, $CaSnO_3$, $SrSnO_3$, $ZnSnO_3$ or $CdSnO_3$ (i.e. $A^3$ : Group 2 or Group 12; $B^3$ : Group 14) and the TCO is lanthanide vanadate, chromate or nickelate such as $LaVO_3$, $LaCrO_3$ or $LaNiO_3$(i.e. $A^1$ : lanthanide; $B^1$ : Group 5, Group 6 or Group 10).

If the formula is $A^1_\alpha A^3_{1-\alpha} B^3 O_{3-\delta_2}$, $A^3$ site substitution of the transparent wide-bandgap semiconductor oxide of the third layer by $A^1$ is present. Examples of such $A^3$ site substitution include where the transparent wide-bandgap semiconductor oxide is $BaSnO_3$ (i.e. $A^3$ : Group 2; $B^3$ : Group 14) and the TCO is $LaNiO_3$ (i.e. $A^1$ : lanthanide; $B^1$ : Group 10).

If the formula is $A^3 B^1_\beta B^3_{1-\beta} O_{3-\delta_2}$, $B^3$ site substitution of the transparent wide-bandgap semiconductor oxide of the third layer by $B^1$ is present. Examples of such $B^3$ site substitution include where the transparent wide-bandgap semiconductor oxide is $SrTiO_3$, $BaSnO_3$ or $LaSnO_3$ (i.e. $A^3$ : Group 2 or lanthanide; $B^3$ : Group 4 or Group 14) and the TCO is $SrNbO_3$, $CaNbO_3$, $SrMoO_3$, $CaMoO_3$ or $SrVO_3$ (i.e. $A^1$ : Group 2; $B^1$ : Group 5 or Group 6).

If the formula is $A^1_\alpha A^3_{1-\alpha} B^1_\beta B^3_{1-\beta} O_{3-\delta_2}$, $A^3$ site substitution of the transparent wide-bandgap semiconductor oxide of the third layer by $A^1$ is present and $B^3$ site substitution of the transparent wide-bandgap semiconductor oxide of the third layer by $B^1$ is present.

In one example, the second layer has an electron mobility in a range from 1 to 100 $cm^2V^{-1}s^{-1}$, a carrier density in a range from $1 \times 10^{20}$ to $1 \times 10^{24}$ $cm^{-3}$, a transmittance in a range from 75% to 100% at a wavelength of 550 nm, a thickness in a ranged from 0.5 to 5 nm, an effective mass in a range from 1 to 10 $m_0$ and/or a conductivity in a range from 1,000 to 100,000 $Scm^{-1}$ at room temperature.

*Examples*

Table 3 includes examples of films according to the first aspect.

Table 3: Example films according to the first aspect.

| First layer | Second layer | Third layer |
|---|---|---|
| transparent conductive oxide aka correlated metal | | transparent wide-bandgap semiconductor |
| $A^1 B^1 O_{3-\delta_1}$ | $A^1_\alpha A^3_{1-\alpha} B^1 O_{3-\delta_2}$ or<br>$A^1_\alpha A^3_{1-\alpha} B^3 O_{3-\delta_2}$ or<br>$A^3 B^1_\beta B^3_{1-\beta} O_{3-\delta_2}$ or<br>$A^1_\alpha A^3_{1-\alpha} B^1_\beta B^3_{1-\beta} O_{3-\delta_2}$ | $A^3 B^3 O_{3-\delta_3}$ |
| $SrNbO_3$ (SNO)<br>$A^1 = Sr$; $B^1 = Nb$ | $Sr(Nb,Ti)O_3$<br>$A^3 B^1_\beta B^3_{1-\beta} O_{3-\delta_2}$<br>$A^3 = Sr$;$B^1 = Nb$;$B^3 = Ti$; $0 < \beta < 1$ | $SrTiO_3$ (STO)<br>$A^3 = Sr$; $B^3 = Ti$ |
| $CaNbO_3$<br>$A^1 = Ca$; $B^1 = Nb$ | $Sr(Nb,Ti)O_3$<br>$A^3 B^1_\beta B^3_{1-\beta} O_{3-\delta_2}$<br>$A^3 = Sr$; $B^1 = Nb$; $B^3 = Ti$; $0 < \beta < 1$ | $SrTiO_3$<br>$A^3 = Sr$; $B^3 = Ti$ |
| $SrVO_3$ | $Sr(V,Ti)O_3$ | $SrTiO_3$ |

(continued)

| First layer | Second layer | Third layer |
|---|---|---|
| transparent conductive oxide aka correlated metal | | transparent wide-bandgap semiconductor |
| $A^1 = Sr$; $B^1 = V$ | $A^3\ B^1_\beta B^3_{1-\beta} O_{3-\delta_2}$ $A^3 = Sr$; $B^1 = V$; $B^3 = Ti$; $0 < \beta < 1$ | $A^3 = Sr$; $B^3 = Ti$ |
| | | |
| $CaVO_3$ $A^1 = Ca$; $B^1 = V$ | $Sr(V,Ti)O_3$ $A^3\ B^1_\beta B^3_{1-\beta} O_{3-\delta_2}$ $A^3 = Sr$; $B^1 = V$; $B^3 = Ti$; $0 < \beta < 1$ | $SrTiO_3$ $A^3 = Sr$; $B^3 = Ti$ |
| $SrMoO_3$ $A^1 = Sr$; $B^1 = Mo$ | $Sr(Mo,Ti)O_3$ $A^3\ B^1_\beta B^3_{1-\beta} O_{3-\delta_2}$ $A^3 = Sr$; $B^1 = Mo$; $B^3 = Ti$; $0 < \beta < 1$ | $SrTiO_3$ $A^3 = Sr$; $B^3 = Ti$ |
| $CaMoO_3$ $A^1 = Ca$; $B^1 = Mo$ $A^3\ B^1_\beta B^3_{1-\beta} O_{3-\delta_2}$ | $Sr(Mo,Ti)O_3$ $A^3 = Sr$; $B^1 = Mo$; $B^3 = Ti$; $0 < \beta < 1$ | $SrTiO_3$ $A^3 = Sr$; $B^3 = Ti$ |
| | | |
| $LaVO_3$ $A^1 = La$; $B^1 = V$ | $Sr(V,Ti)O_3$ $A^3\ B^1_\beta B^3_{1-\beta} O_{3-\delta_2}$ $A^3 = Sr$; $B^1 = V$; $B^3 = Ti$; $0 < \beta < 1$ | $SrTiO_3$ $A^3 = Sr$; $B^3 = Ti$ |
| $LaCrO_3$ $A^1 = La$; $B^1 = Cr$ | $Sr(Cr,Ti)O_3$ $A^3\ B^1_\beta B^3_{1-\beta} O_{3-\delta_2}$ $A^3 = Sr$; $B^1 = Cr$; $B^3 = Ti$; $0 < \beta < 1$ | $SrTiO_3$ $A^3 = Sr$; $B^3 = Ti$ |
| | | |
| $LaNiO_3$ $A^1 = La$; $B^1 = Ni$ | $(La,Ba)SnO_3$ $A^1_\alpha A^3_{1-\alpha} B^3\ O_{3-\delta_2}$ $A^1 = La$; $A^3 = Ba$; $B^3 = Sn$; $0 < \alpha < 1$ | $BaSnO_3$ $A^3 = Ba$; $B^3 = Sn$ |
| $LaNiO_3$ $A^1 = La$; $B^1 = Ni$ | $(La,Ca)SnO_3$ $A^1_\alpha A^3_{1-\alpha} B^3\ O_{3-\delta_2}$ $A^1 = La$; $A^3 = Ca$; $B^3 = Sn$; $0 < \alpha < 1$ | $CaSnO_3$ $A^3 = Ca$; $B^3 = Sn$ |
| $LaNiO_3$ $A^1 = La$; $B^1 = Ni$ | $(La,Sr)SnO_3$ $A^1_\alpha A^3_{1-\alpha} B^3\ O_{3-\delta_2}$ $A^1 = La$; $A^3 = Sr$; $B^3 = Sn$; $0 < \alpha < 1$ | $SrSnO_3$ $A^3 = Sr$; $B^3 = Sn$ |
| $LaNiO_3$ $A^1 = La$; $B^1 = Ni$ | $(La,Zn)SnO_3$ $A^1_\alpha A^3_{1-\alpha} B^3\ O_{3-\delta_2}$ $A^1 = La$; $A^3 = Zn$; $B^3 = Sn$; $0 < \alpha < 1$ | $ZnSnO_3$ $A^3 = Zn$; $B^3 = Sn$ |
| $LaNiO_3$ $A^1 = La$; $B^1 = Ni$ | $(La,Cd)SnO_3$ $A^1_\alpha A^3_{1-\alpha} B^3\ O_{3-\delta_2}$ $A^1 = La$; $A^3 = Cd$; $B^3 = Sn$; $0 < \alpha < 1$ | $CdSnO_3$ $A^3 = Cd$; $B^3 = Sn$ |
| | | |

(continued)

| First layer | Second layer | Third layer |
|---|---|---|
| transparent conductive oxide aka correlated metal | | transparent wide-bandgap semiconductor |
| A(V or Nb or Ta or Cr or Mo or W)$O_3$ where A is an alkaline earth element, preferably Ca, Sr, Ba | Transition metal doped $BaTiO_3$ | $BaTiO_3$ |
| A(V or Nb or Ta or Cr or Mo or W)$O_3$ where A is an alkaline earth element, preferably Ca, Sr, Ba | Transition metal doped $SrTiO_3$ | $SrTiO_3$ |
| A(V or Nb or Ta or Cr or Mo or W)$O_3$ where A is an alkaline earth element, preferably Ca, Sr, Ba | Transition metal doped $CaTiO_3$ | $CaTiO_3$ |
| A(V or Nb or Ta or Cr or Mo or W)$O_3$ where A is an alkaline earth element, preferably Ca, Sr, Ba | Transition metal doped $ZnTiO_3$ | $ZnTiO_3$ |
| | | |

Table 4 includes examples of films according to the first aspect. $A^1$ and $B^1$ of the first layer and $A^3$ and $B^3$ of the third layer are shown and the compositions of the third layer shown at the intersections, thereby indicating the doping species. 1-x and x are analogous to 1 - $\alpha$ and $\alpha$, respectively. Oxygen content is nominal i.e. generally $O_{3-\delta_2}$.

Table 4: Example films according to the first aspect.

| | $A^3$ | Ca | Ca | Sr | Sr | Ba | Ba | Zn | Zn | Cd | Cd | La | La | Pr | Pr | Nd | Nd |
|---|---|---|---|---|---|---|---|---|---|---|---|---|---|---|---|---|---|
| | $B^3$ | Ti | Sn | Ti | Sn | Ti | Sn | Ti | Sn | Ti | Sn | Ti | Sn | Ti | Sn | Ti | Sn |
| $A^1$ | $B^1$ | | | | | | | | | | | | | | | | |
| Ca | V | CaTi1-xVxO3 | | SrTi1-xVxO3 | | BaTi1-xVxO3 | | ZnTi1-xVxO3 | | CdTi1-xVxO3 | | LaTi1-xVxO3 | Ca1-xLaxSnO3 | PrTi1-xVxO3 | Ca1-xPrxSnO3 | NdTi1-xVxO3 | Ca1-xNdxSnO3 |
| Ca | Nb | CaTi1-xNbxO3 | | SrTi1-xNbxO3 | | BaTi1-xNbxO3 | | ZnTi1-xNbxO3 | | CdTi1-xNbxO3 | | LaTi1-xNbxO3 | Ca1-xLaxSnO3 | PrTi1-xNbxO3 | Ca1-xPrxSnO3 | NdTi1-xNbxO3 | Ca1-xNdxSnO3 |
| Ca | Ta | CaTi1-xTaxO3 | | SrTi1-xTaxO3 | | BaTi1-xTaxO3 | | ZnTi1-xTaxO3 | | CdTi1-xTaxO3 | | LaTi1-xTaxO3 | Ca1-xLaxSnO3 | PrTi1-xTaxO3 | Ca1-xPrxSnO3 | NdTi1-xTaxO3 | Ca1-xNdxSnO3 |
| Ca | Cr | CaTi1-xCncO3 | | SrTi1-xCrxO3 | | BaTi1-xCrxO3 | | ZnTi1-xCrxO3 | | CdTi1-xCrxO3 | | LaTi1-xCrxO3 | Ca1-xLaxSnO3 | PrTi1-xCrxO3 | Ca1-xPrxSnO3 | NdTi1-xCrxO3 | Ca1-xNdxSnO3 |
| Ca | Mo | CaTi1-xMoxO3 | | SrTi1-xMoxO3 | | BaTi1-xMoxO3 | | ZnTi1-xMoxO3 | | CdTi1-xMoxO3 | | LaTi1-xMoxO3 | Ca1-xLaxSnO3 | PrTi1-xMoxO3 | Ca1-xPrxSnO3 | NdTi1-xMoxO3 | Ca1-xNdxSnO3 |
| Ca | W | CaTi1-xWxO3 | | SrTi1-xWxO3 | | BaTi1-xWxO3 | | ZnTi1-xWxO3 | | CdTi1-xWxO3 | | LaTi1-xWxO3 | Ca1-xLaxSnO3 | PrTi1-xWxO3 | Ca1-xPrxSnO3 | NdTi1-xWxO3 | Ca1-xNdxSnO3 |
| Ca | Ni | CaTi1-xNixO3 | | SrTi1-xNixO3 | | BaTi1-xNixO3 | | ZnTi1-x NixO3 | | CdTi1-xNixO3 | | LaTi1-xNixO3 | Ca1-xLaxSnO3 | PrTi1-xNixO3 | Ca1-xPrxSnO3 | NdTi1-xNixO3 | Ca1-xNdxSnO3 |
| Sr | V | CaTi1-xVxO3 | | SrTi1-xVxO3 | | BaTi1-xVxO3 | | ZnTi1-xVxO3 | | CdTi1-xVxO3 | | LaTi1-xVxO3 | Sr1-xPrxSnO3 | PrTi1-xVxO3 | Sr1-xPrxSnO3 | NdTi1-xVxO3 | Sr1-xNdxSnO3 |
| Sr | Nb | CaTi1-xNbxO3 | | SrTi1-xNbxO3 | | BaTi1-xNbxO3 | | ZnTi1-xNbxO3 | | CdTi1-xNbxO3 | | LaTi1-xNbxO3 | Sr1-xPrxSnO3 | PrTi1-xNbxO3 | Sr1-xPrxSnO3 | NdTi1-xNbxO3 | Sr1-xNdxSnO3 |
| Sr | Ta | CaTi1-xTaxO3 | | SrTi1-xTaxO3 | | BaTi1-xTaxO3 | | ZnTi1-xTaxO3 | | CdTi1-xTaxO3 | | LaTi1-xTaxO3 | Sr1-xPrxSnO3 | PrTi1-xTaxO3 | Sr1-xPrxSnO3 | NdTi1-xTaxO3 | Sr1-xNdxSnO3 |
| Sr | Cr | CaTi1-xCrxO3 | | SrTi1-xCrxO3 | | BaTi1-xCrxO3 | | ZnTi1-xCrxO3 | | CdTi1-xCrxO3 | | LaTi1-xCrxO3 | Sr1-xPrxSnO3 | PrTi1-xCrxO3 | Sr1-xPrxSnO3 | NdTi1-xCrxO3 | Sr1-xNdxSnO3 |
| Sr | Mo | CaTi1-xMoxO3 | | SrTi1-xMoxO3 | | BaTi1-xMoxO3 | | ZnTi1-xMoxO3 | | CdTi1-xMoxO3 | | LaTi1-xMoxO3 | Sr1-xPrxSnO3 | PrTi1-xMoxO3 | Sr1-xPrxSnO3 | NdTi1-xMoxO3 | Sr1-xNdxSnO3 |
| Sr | W | CaTi1-xWxO3 | | SrTi1-xWxO3 | | BaTi1-xWxO3 | | ZnTi1-xWxO3 | | CdTi1-xWxO3 | | LaTi1-xWxO3 | Sr1-xPrxSnO3 | PrTi1-xWxO3 | Sr1-xPrxSnO3 | NdTi1-xWxO3 | Sr1-xNdxSnO3 |
| Sr | Ni | CaTi1-xNixO3 | | SrTi1-xNixO3 | | BaTi1-xNixO3 | | ZnTi1-x NixO3 | | CdTi1-xNixO3 | | LaTi1-xNixO3 | Sr1-xNdxSnO3 | PrTi1-xNixO3 | Sr1-xPrxSnO3 | NdTi1-xNixO3 | Sr1-xNdxSnO3 |
| Ba | V | CaTi1-xVxO3 | | SrTi1-xVxO3 | | BaTi1-xVxO3 | | ZnTi1-xVxO3 | | CdTi1-xVxO3 | | LaTi1-xVxO3 | Ba1-xNdxSnO3 | PrTi1-xVxO3 | Ba1-xPrxSnO3 | NdTi1-xVxO3 | Ba1-xNdxSnO3 |

(continued)

| | $A^3$ | Ca | Ca | Sr | Sr | Ba | Ba | Zn | Zn | Cd | Cd | La | La | Pr | Pr | Nd | Nd |
|---|---|---|---|---|---|---|---|---|---|---|---|---|---|---|---|---|---|
| | $B^3$ | Ti | Sn | Ti | Sn | Ti | Sn | Ti | Sn | Ti | Sn | Ti | Sn | Ti | Sn | Ti | Sn |
| $A^1$ | $B^1$ | | | | | | | | | | | | | | | | |
| Ba | Nb | CaTi1-xNbxO3 | | SrTi1-xNbxO3 | | BaTi1-xNbxO3 | | ZnTi1-xNbxO3 | | CdTi1-xNbxO3 | | LaTi1-xNbxO3 | Ba1-xNdxSnO3 | PrTi1-xNbxO3 | Ba1-xPrxSnO3 | NdTi1-xNbxO3 | Ba1-xNdxSnO3 |
| Ba | Ta | CaTi1-xTaxO3 | | SrTi1-xTaxO3 | | BaTi1-xTaxO3 | | ZnTi1-xTaxO3 | | CdTi1-xTaxO3 | | LaTi1-xTaxO3 | Ba1-xNdxSnO3 | PrTi1-xTaxO3 | Ba1-xPrxSnO3 | NdTi1-xTaxO3 | Ba1-xNdxSnO3 |
| Ba | Cr | CaTi1-xCrxO3 | | SrTi1-xCrxO3 | | BaTi1-xCrxO3 | | ZnTi1-xCrxO3 | | CdTi1-xCrxO3 | | LaTi1-xCrxO3 | Ba1-xNdxSnO3 | PrTi1-xCrxO3 | Ba1-xPrxSnO3 | NdTi1-xCrxO3 | Ba1-xNdxSnO3 |
| Ba | Mo | CaTi1-xMoxO3 | | SrTi1-xMoxO3 | | BaTi1-xMoxO3 | | ZnTi1-xMoxO3 | | CdTi1-xMoxO3 | | LaTi1-xMoxO3 | Ba1-xNdxSnO3 | PrTi1-xMoxO3 | Ba1-xPrxSnO3 | NdTi1-xMoxO3 | Ba1-xNdxSnO3 |
| Ba | W | CaTi1-xWxO3 | | SrTi1-xWxO3 | | BaTi1-xWxO3 | | ZnTi1-xWxO3 | | CdTi1-xWxO3 | | LaTi1-xWxO3 | Ba1-xNdxSnO3 | PrTi1-xWxO3 | Ba1-xPrxSnO3 | NdTi1-xWxO3 | Ba1-xNdxSnO3 |
| Ba | Ni | CaTi1-xNixO3 | | SrTi1-xNixO3 | | BaTi1-xNixO3 | | ZnTi1-xNixO3 | | CdTi1-xNixO3 | | LaTi1-xNixO3 | Ba1-xNdxSnO3 | PrTi1-xNixO3 | Ba1-xPrxSnO3 | NdTi1-xNixO3 | Ba1-xNdxSnO3 |
| La | V | CaTi1-xVxO3 | Ca1-xLaxSnO3 | SrTi1-xVxO3 | Sr1-xLaxS-nO3 | BaTi1-xVxO3 | Ba1-xLaxS-nO3 | ZnTi1-xVxO3 | Zn1-xLaxS-nO3 | CdTi1-xVxO3 | Cd1-x LaxSnO3 | LaTi1-xVxO3 | | PrTi1-xVxO3 | | NdTi1-xVxO3 | |
| La | Nb | CaTi1-xNbxO3 | Ca1-xLaxSnO3 | SrTi1-xNbxO3 | Sr1-xLaxS-nO3 | BaTi1-xNbxO3 | Ba1-xLaxS-nO3 | ZnTi1-xNbxO3 | Zn1-xLaxS-nO3 | CdTi1-xNbxO3 | Cd1-x LaxSnO3 | LaTi1-xNbxO3 | | PrTi1-xNbxO3 | | NdTi1-xNbxO3 | |
| La | Ta | CaTi1-xTaxO3 | Ca1-xLaxSnO3 | SrTi1-xTaxO3 | Sr1-xLaxS-nO3 | BaTi1-xTaxO3 | Ba1-xLaxS-nO3 | ZnTi1-xTaxO3 | Zn1-xLaxS-nO3 | CdTi1-xTaxO3 | Cd1-x LaxSnO3 | LaTi1-xTaxO3 | | PrTi1-xTaxO3 | | NdTi1-xTaxO3 | |
| La | Cr | CaTi1-xCrxO3 | Ca1-xLaxSnO3 | SrTi1-xCrxO3 | Sr1-xLaxS-nO3 | BaTi1-xCrxO3 | Ba1-xLaxS-nO3 | ZnTi1-xCrxO3 | Zn1-xLaxS-nO3 | CdTi1-xCrxO3 | Cd1-x LaxSnO3 | LaTi1-xCrxO3 | | PrTi1-xCrxO3 | | NdTi1-xCrxO3 | |
| La | Mo | CaTi1-xMoxO3 | Ca1-xLaxSnO3 | SrTi1-xMoxO3 | Sr1-xLaxS-nO3 | BaTi1-xMoxO3 | Ba1-xLaxS-nO3 | ZnTi1-xMoxO3 | Zn1-xLaxS-nO3 | CdTi1-xMoxO3 | Cd1-x LaxSnO3 | LaTi1-xMoxO3 | | PrTi1-xMoxO3 | | NdTi1-xMoxO3 | |
| La | W | CaTi1-xWxO3 | Ca1-xLaxSnO3 | SrTi1-xWxO3 | Sr1-xLaxS-nO3 | BaTi1-xWxO3 | Ba1-xLaxS-nO3 | ZnTi1-xWxO3 | Zn1-xLaxS-nO3 | CdTi1-xWxO3 | Cd1-x LaxSnO3 | LaTi1-xWxO3 | | PrTi1-xWxO3 | | NdTi1-xWxO3 | |
| La | Ni | CaTi1-xNixO3 | Ca1-xLaxSnO3 | SrTi1-xNixO3 | Sr1-xLaxS-nO3 | BaTi1-xNixO3 | Ba1-xLaxS-nO3 | ZnTi1-x NixO3 | Zn1-xLaxSnO3 | CdTi1-xNixO3 | Cd1-x LaxSnO3 | LaTi1-xNixO3 | | PrTi1-xNixO3 | | NdTi1-xNixO3 | |
| Pr | V | CaTi1-xVxO3 | Ca1-xPrxSnO3 | SrTi1-xVxO3 | Sr1-xPrxSnO3 | BaTi1-xVxO3 | Ba1-xPrxSnO3 | ZnTi1-xVxO3 | Zn1-xPrxSnO3 | CdTi1-xVxO3 | Cd1-xPrxSnO3 | LaTi1-xVxO3 | | PrTi1-xVxO3 | | NdTi1-xVxO3 | |
| Pr | Nb | CaTi1-xNbxO3 | Ca1-xPrxSnO3 | SrTi1-xNbxO3 | Sr1-xPrxSnO3 | BaTi1-xNbxO3 | Ba1-xPrxSnO3 | ZnTi1-xNbxO3 | Zn1-xPrxSnO3 | CdTi1-xNbxO3 | Cd1-xPrxSnO3 | LaTi1-xNbxO3 | | PrTi1-xNbxO3 | | NdTi1-xNbxO3 | |

(continued)

| | $A^3$ | Ca | Ca | Sr | Sr | Ba | Ba | Zn | Zn | Cd | Cd | La | La | Pr | Pr | Nd | Nd |
|---|---|---|---|---|---|---|---|---|---|---|---|---|---|---|---|---|---|
| | $B^3$ | Ti | Sn | Ti | Sn | Ti | Sn | Ti | Sn | Ti | Sn | Ti | Sn | Ti | Sn | Ti | Sn |
| $A^1$ | $B^1$ | | | | | | | | | | | | | | | | |
| Pr | Ta | CaTi1-xTaxO3 | Ca1-xPrxSnO3 | SrTi1-xTaxO3 | Sr1-xPrxSnO3 | BaTi1-xTaxO3 | Ba1-xPrxSnO3 | ZnTi1-xTaxO3 | Zn1-xPrxSnO3 | CdTi1-xTaxO3 | Cd1-xPrxSnO3 | LaTi1-xTaxO3 | | PrTi1-xTaxO3 | | NdTi1-xTaxO3 | |
| Pr | Cr | CaTi1-xCncO3 | Ca1-xPrxSnO3 | SrTi1-xCrxO3 | Sr1-xPrxSnO3 | BaTi1-xCrxO3 | Ba1-xPrxSnO3 | ZnTi1-xCrxO3 | Zn1-xPrxSnO3 | CdTi1-xCrxO3 | Cd1-xPrxSnO3 | LaTi1-xCrxO3 | | PrTi1-xCrxO3 | | NdTi1-xCrxO3 | |
| Pr | Mo | CaTi1-xMoxO3 | Ca1-xPrxSnO3 | SrTi1-xMoxO3 | Sr1-xPrxSnO3 | BaTi1-xMoxO3 | Ba1-xPrxSnO3 | ZnTi1-xMoxO3 | Zn1-xPrxSnO3 | CdTi1-xMoxO3 | Cd1-xPrxSnO3 | LaTi1-xMoxO3 | | PrTi1-xMoxO3 | | NdTi1-xMoxO3 | |
| Pr | W | CaTi1-xWxO3 | Ca1-xPrxSnO3 | SrTi1-xWxO3 | Sr1-xPrxSnO3 | BaTi1-xWxO3 | Ba1-xPrxSnO3 | ZnTi1-xWxO3 | Zn1-xPrxSnO3 | CdTi1-xWxO3 | Cd1-xPrxSnO3 | LaTi1-xWxO3 | | PrTi1-xWxO3 | | NdTi1-xWxO3 | |
| Pr | Ni | CaTi1-xNixO3 | Ca1-xNdxSnO3 | SrTi1-xNixO3 | Sr1-xNdxSnO3 | BaTi1-xNixO3 | Ba1-xNdxSnO3 | ZnTi1-x NixO3 | Zn1-xNdxSnO3 | CdTi1-xNixO3 | Cd1-xNdxSnO3 | LaTi1-xNixO3 | | PrTi1-xNixO3 | | NdTi1-xNixO3 | |
| Nd | V | CaTi1-xVxO3 | Ca1-xNdxSnO3 | SrTi1-xVxO3 | Sr1-xNdxSnO3 | BaTi1-xVxO3 | Ba1-xNdxSnO3 | ZnTi1-xVxO3 | Zn1-xNdxSnO3 | CdTi1-xVxO3 | Cd1-xNdxSnO3 | LaTi1-xVxO3 | | PrTi1-xVxO3 | | NdTi1-xVxO3 | |
| Nd | Nb | CaTi1-xNbxO3 | Ca1-xNdxSnO3 | SrTi1-xNbxO3 | Sr1-xNdxSnO3 | BaTi1-xNbxO3 | Ba1-xNdxSnO3 | ZnTi1-xNbxO3 | Zn1-xNdxSnO3 | CdTi1-xNbxO3 | Cd1-xNdxSnO3 | LaTi1-xNbxO3 | | PrTi1-xNbxO3 | | NdTi1-xNbxO3 | |
| Nd | Ta | CaTi1-xTaxO3 | Ca1-xNdxSnO3 | SrTi1-xTaxO3 | Sr1-xNdxSnO3 | BaTi1-xTaxO3 | Ba1-xNdxSnO3 | ZnTi1-xTaxO3 | Zn1-xNdxSnO3 | CdTi1-xTaxO3 | Cd1-xNdxSnO3 | LaTi1-xTaxO3 | | PrTi1-xTaxO3 | | NdTi1-xTaxO3 | |
| Nd | Cr | CaTi1-xCrxO3 | Ca1-xNdxSnO3 | SrTi1-xCrxO3 | Sr1-xNdxSnO3 | BaTi1-xCrxO3 | Ba1-xNdxSnO3 | ZnTi1-xCrxO3 | Zn1-xNdxSnO3 | CdTi1-xCrxO3 | Cd1-xNdxSnO3 | LaTi1-xCrxO3 | | PrTi1-xCrxO3 | | NdTi1-xCrxO3 | |
| Nd | Mo | CaTi1-xMoxO3 | Ca1-xNdxSnO3 | SrTi1-xMoxO3 | Sr1-xNdxSnO3 | BaTi1-xMoxO3 | Ba1-xNdxSnO3 | ZnTi1-xMoxO3 | Zn1-xNdxSnO3 | CdTi1-xMoxO3 | Cd1-xNdxSnO3 | LaTi1-xMoxO3 | | PrTi1-xMoxO3 | | NdTi1-xMoxO3 | |
| Nd | W | CaTi1-xWxO3 | Ca1-xNdxSnO3 | SrTi1-xWxO3 | Sr1-xNdxSnO3 | BaTi1-xWxO3 | Ba1-xNdxSnO3 | ZnTi1-xWxO3 | Zn1-xNdxSnO3 | CdTi1-xWxO3 | Cd1-xNdxSnO3 | LaTi1-xWxO3 | | PrTi1-xWxO3 | | NdTi1-xWxO3 | |
| Nd | Ni | CaTi1-xNixO3 | Ca1-xNdxSnO3 | SrTi1-xNixO3 | Sr1-xNdxSnO3 | BaTi1-xNixO3 | Ba1-xNdxSnO3 | ZnTi1-x NixO3 | Zn1-xNdxSnO3 | CdTi1-xNixO3 | Cd1-xNdxSnO3 | LaTi1-xNixO3 | | PrTi1-xNixO3 | | NdTi1-xNixO3 | |

In one example, the second layer comprises and/or is a compositionally-graded layer, optionally having a linear composition gradient therethrough. In this way, the carrier concentration is increased (and hence the overall conductivity) while the transparency is governed by the bulk of the heterostructure (correlated metal).

In one example, the second layer has a thickness in a range from 0.5 Å to 100 Å, preferably in a range from 2 Å to 80 Å, more preferably in a range from 5 Å to 50 Å, most preferably in a range from 10 Å to 25 Å.

***Electrode***

The second aspect provides an electrode comprising a film according to the first aspect on a substrate.

In one example, the electrode is included in a display screen, photovoltaics, energy saving glazing, a touch screens and/or a LED.

An aspect provides a device, for example a display screen, photovoltaics, energy saving glazing, a touch screens and/or a LED, comprising an electrode according to the second aspect.

***Method***

The third aspect provides a method of providing a film according to the first aspect, comprising: depositing the first layer on the third layer, for example by pulsed laser deposition.

In one example, the method comprises diffusing at least some of $B^1$ (i.e. from the TCO) into the third layer (i.e. into the transparent wide-bandgap semiconductor), thereby providing the second layer.

***Definitions***

Throughout this specification, the term "comprising" or "comprises" means including the component(s) specified but not to the exclusion of the presence of other components. The term "consisting essentially of" or "consists essentially of" means including the components specified but excluding other components except for materials present as impurities, unavoidable materials present as a result of processes used to provide the components, and components added for a purpose other than achieving the technical effect of the invention, such as colourants, and the like.

The term "consisting of' or "consists of' means including the components specified but excluding other components.

Whenever appropriate, depending upon the context, the use of the term "comprises" or "comprising" may also be taken to include the meaning "consists essentially of' or "consisting essentially of", and also may also be taken to include the meaning "consists of" or "consisting of".

The optional features set out herein may be used either individually or in combination with each other where appropriate as long as the resulting combinations fall within the scope of the invention as defined in the accompanying claims.

**Brief description of the drawings**

For a better understanding of the invention, and to show how exemplary embodiments of the same may be brought into effect, reference will be made, by way of example only, to the accompanying diagrammatic Figures, in which:

Figure 1 schematically depicts the effect of increased electrical conductivity and diminished optical transmission progressing from:

i) a single $SrNbO_3$ film of thickness t and region of charge transfer of thickness $t_{CT}$ at the interface with the $SrTiO_3$ substrate;
ii) A $SrNbO_3$ film of thickness t, a $SrTi_{1-x}Nb_xO_3$ interface layer of thickness $t_{Int}$ and fixed Nb content, x and a region of charge transfer of thickness $t_{CT}$ at the interface with the $SrTiO_3$ substrate;
iii) a $SrNbO_3$ film of thickness t with a graded interface of $SrTi_{1-x}Nb_xO_3$ of thickness $t_{Int}$ and Nb content, $1 \leq x \leq 0$, and a region of charge transfer of thickness $t_{CT}$ at the interface with the $SrTiO_3$ substrate; and
iv) a $SrTi_{1-x}Nb_xO_3$ film with a fixed Nb content, x and a sharp interface with the $SrTiO_3$ substrate.

Figure 2A shows measured and simulated HAADF-STEM images indicating the graded interface of 3 unit cells thickness (orange rectangle). The simulated image is overlaid with the cation assignment at each bright spot, Sr in red, Ti in blue, Nb in green and oxygen in white. Figure 2B shows average oxidation state of 20 nm and 80 nm (nominal thickness) $SrNbO_3$ films on $SrTiO_3$ (pink star) and $DyScO_3$ (orange square) substrates extracted from XANES with measured standards (black squares) and calculated linear trend of average oxidation state against absorption edge

energy. Figure 2C shows the measured carrier concentration of the $SrNbO_3/SrTi_{1-x}Nb_xO_3/SrTiO_3$ system (green open circles) as calculated with film thickness measured from XRR, t. Model (blue dashed line) showing the predicted carrier concentration with film thickness when considering an additional charge transfer thickness, $t_{CT}$ of 10 nm. Theoretical carrier concentration of $SrNbO_3$ (black solid line). Figure 2D shows HAADF-STEM intensity versus depth showing the compositional change across the graded layer. Figure 2E shows carrier mobility as a function of temperature for a 17 nm $SrNbO_3$ film on $SrTiO_3$ (black open squares) and a 16 nm $SrNbO_3$ film on LSAT (black solid squares).

Figure 3A is a graph of measured transmittance as a function of wavelength for four films; and Figure 3B is a graph of Haacke figure of merit (FOM) as a function of film thickness for SNO on STO and $CaNbO_3$ on STO.

Figure 4A is a graph of normalised intensity as a function of $2\theta$ for 74 nm SNO on STO; Figure 4B is a graph of intensity as a function of $\omega$ for 74 nm SNO on STO; Figure 4C is a graph of intensity as a function of $2\theta$ for SNO on STO (111). Film deposited on other substrate orientation (STO (111)) grows highly crystalline in same condition. Shows the similar low room temperature sheet resistance as films on STO (001). Figure 4D is a graph of oxidation state as a function of energy for different films. Thick sample (74nm) on STO and thick (80nm) and thin (20nm) samples on DSO show oxidation state close to 4+. Thinner (20nm) sample on STO shows slightly increased oxidation state which could be interpreted as a small amount of Nb diffusion into the STO substrate at the interface.

Figure 5 schematically depicts a film according to an exemplary embodiment.

Figure 6 is a graph of carrier concentration as a function of temperature for $SrNbO_3$ films for a series of thicknesses (2 nm, 5 nm, 19 nm, 39 nm, 61 nm and 74 nm) on $SrTiO_3$ substrates.

Figure 7 is a graph of carrier mobility as a function of temperature for $SrNbO_3$ films for a series of thicknesses (2 nm, 5 nm, 19 nm, 39 nm, 61 nm and 74 nm) on $SrTiO_3$ substrates.

## Detailed Description of the Drawings

Although these interfacial properties have been widely studied, they are difficult to harness into application. LAO/STO heterostructures are made with precise techniques, requiring specific substrate termination and an exact number of unit cells to observe the effect. This kind of carefully controlled growth is time-consuming, and specific substrate termination requires chemical etching, often with toxic acids such as HF. Moreover, the charge is localised at the interface in a few unit cells and difficult to access.

$SrTiO_3$ is a transparent semiconductor with a band gap of 3.2 eV and an extraordinarily high dielectric constant $\varepsilon_r \approx 300$ at room temperature, to tens of thousands at low temperatures. Electronic conduction can be induced with chemical dopants such as substitution of $La^{3+}$ for $Sr^{2+}$, $Nb^{5+}$ for $Ti^{4+}$ or by reduction of $SrTiO_{3-\delta}$, where each oxygen vacancy generates two doped electrons. Doped $SrTiO_3$ exhibits a high-mobility metallic state with a strongly temperature dependent resistivity. At 4K, the electron mobility can reach over 20,000 $cm^2V^{-1}s^1$, [Spinelli 2010] compared with conventional metals such as Au, Ag and Cu typically <100 $cm^2V^{-1}s^{-1}$ and correlated metals such as $Sr(Ca)VO_3$ and $Sr(Ca)MoO_3$ between 2 and 20 $cm^2V^{-1}s^{-1}$. [Zhang (2015) N Mat, Stoner (2019) Adv. Fun. Mat.] $SrNbO_3$ is a $4d^1$ correlated metal oxide with a minimum reported sheet resistance of 7.3Ω/□ (thickness dependent, [Park (2020) Comm. Phys 3:102]) and a plasma frequency reported between 1.65 - 1.98 eV [Wan (2017) Nat Comm 1-8, 9, Park (2020) Comm. Phys 3:102].

An abrupt interface between the correlated metal and semiconductor with a large difference in carrier concentration would generate an electrostatic barrier and prevent the injection of highly mobile carriers into the metal. To overcome this, a graded interfacial layer is formed between the metal and the semiconductor. This concept is employed in conventional semiconductor applications such as High Electron Mobility Transistors (HEMTs), where the semiconductors used have dissimilar band gaps. The band discontinuities across the interface can be modified to form a continuous level by grading the transition from one semiconductor to the other. In a traditional HEMT device, the diffusion of carriers leads to the accumulation of the electrons along the boundary, forming a 2D electron gas (2DEG). Applying this concept to the correlated metal-semiconductor junction, the graded interface created would allow access to the highly mobile carriers while the transparency is governed by the bulk of the heterostructure, i.e. the correlated metal.

$SrNbO_3$ is a highly conducting, metallic oxide with cubic perovskite structure. Studies have previously shown its applications in photocatalysis and recently, it has been shown to be an effective transparent conductor in the visible and UV spectra, with a maximum figure of merit similar to other correlated metal TCOs. To create a graded correlated metal-semiconductor heterointerface, we have grown $SrNbO_3$ thin films over a series of thicknesses on $SrTiO_3$ substrates and studied their structural interface and, electrical and optical properties. The growth conditions allow for reduction of the $SrTiO_3$ substrate surface and niobium diffusion to create a graded interfacial layer with the $SrNbO_3$ film. Highly (0 0 1)

oriented $SrNbO_3$ films have been obtained with an average root mean squared (RMS) surface roughness of 0.2 nm for a film thickness of 17nm, up to a maximum of 0.9 nm for a film thickness of 132nm (Figure S5, Supporting Information). The lattice parameters for $SrNbO_3$ were calculated from reciprocal space mapping and out-of-plane diffraction with a = 3.99(3) Å, b = 4.01(3) Å in-plane and c = 4.07(1) Å suggesting a small tetragonal distortion with c/a = 1.02 Å. The in-plane lattice parameters are close to the reported value for bulk cubic $SrNbO_3$ with $a_{bulk}$ = 4.024 Å. The lattice mismatch between $SrNbO_3$ and $SrTiO_3$ is -2.96% and the rocking curve presents a broad Gaussian (FWHM 1.48(5)°) and narrow Lorentzian component (FWHM 0.074(1)°), which indicate the presence of dislocations in the films. High angle annular dark field scanning transmission electron microscopy (HAADF-STEM) images (Figure 2A)) show the interfacial region were Ti and Nb cation intermixing occurs to create a gradual transition from correlated metal to semiconductor. Experimental and simulated intensity profiles (Figure 2D) indicate cation grading over three atomic layers, approximately a thickness of 12.2 Å.

The average oxidation state of niobium in the film was determined from x-ray absorption near-edge spectroscopy (XANES) (Figure 2B). The contribution of the interface region in the 80nm sample has minimal effect on the average oxidation state to its small proportion of the whole system and is therefore saturated by the bulk $SrNbO_3$ properties. Films of nominal thicknesses 80nm and 20nm on $DyScO_3$ substrates, in which charge transfer or cation diffusion is not expected, show an average oxidation state of 3.94(9)+ and 4.01(9)+, within error on the nominal 4+. $SrNbO_3$ films of nominal thicknesses 80nm and 20nm on $SrTiO_3$ substrates were measured and show average oxidation states of +4.05(9) and +4.35(9) respectively. The intermixing of B-site cations at the interface alone is not enough to produce this magnitude of increased oxidation state. For an average increase of 0.35+, there would need to be a minimum diffusion interface thickness of 7nm of $Nb^{5+}$ (where x = 1.0 in $SrNb_x Ti_{1-x}O_3$). From TEM there is only 1.22nm of cation diffusion. It can also be assumed that surface oxidation and $Nb^{5+}$ defects in the film would not cause a significant increase. Charge transfer in the 20nm contributes significantly to the average oxidation state of the system, with approximately 35% $Nb^{5+}$ resulting in electronically active $Ti^{3+}$. This is consistent with the predicted charge transfer of $\Delta n_e$ = 0.36 from Zhong and Hansmann.

Figure 2C show the measured carrier concentration of $SrNbO_3$ films as a function of films thickness. The carrier concentration values are calculated using the film thickness measured using x-ray reflectivity, which does not consider the additional electronically active charge transfer region $t_{CT}$ as indicated in figure 1 i) and ii). The seeming increase in carrier concentration is caused by the underestimation of the total electronically active thickness, t + $t_{CT}$, where $t_{CT}$ is depth of the charge transfer into the $SrTiO_3$ substrate. In figure 2c, the model shows the change of carrier concentration with film thickness if an additional electronically active thickness $t_{CT}$ = 10nm is accounted for.

Low effective mass observed explained from the band structure of STO doped with Nb: at high x(Nb) light electron dominate the transport.

The room temperature resistivities of the $SrNbO_3$ films with thicknesses in the range of 2 to 74 nm on $SrTiO_3$ substrates, varied between 4.4(8) $\mu\Omega$cm and 12.8(4) $\mu\Omega$cm, more than an order of magnitude lower than the lowest reported value of 28.2 $\mu\Omega$cm for $SrNbO_3$ films on other substrates (Oka, Phys. Rev. B 92, 205102 (2015)). With decreasing film thickness, the room temperature resistivity tended to decrease. This is attributed to the electronically active charge transfer region, where the highly mobile, light carriers from the electron doped $SrTiO_3$ form a larger proportion of the whole system. The thinnest film of nominal thickness 2 nm shows a slight increase in resistivity, due to the film thickness being reduced below the electron mean free path (EMFP) of 3.5nm and introducing surface scattering. [Park (2020) Comm. Phys 3:102].

At 2K, the resistivity in all films the resistivity decreases by three orders of magnitude, resulting in exceptionally large resistivity ratios (RRR > 1000) compared to usual reported values for epitaxial perovskite films (< 10), though similar to those reported for carrier doped $SrTiO_3$ (Spinelli et al. 2010). Our experimental results show a maximum (RRR) = $\rho$(300 K)/(2 K) = 3122. $SrNbO_3$ films were also deposited on LSAT (0 0 1) and $DyScO_3$ (1 1 0) (DSO) substrates, where no charge transfer or Nb diffusion is expected. For a film thickness of 70 nm on DSO $\rho$(300k) = 49 $\mu\Omega$cm and on 16nm on LSAT $\rho$ (300k) = 70 $\mu\Omega$cm, within the same order of magnitude of the values previously reported. Transport results and further details are shown in Table 5.

Table 5: Electrical transport data for a series of thickness of $SrNbO_3$ films on $SrTiO_3$, $DyScO_3$ and LSAT substrates. *The Hall resistance could not be measured due to the paramagnetic nature of $DyScO_3$.

| Substrate | $SrNbO_3$ Film Thickness (nm) | $\rho$(300K) ($\mu\Omega$cm) | $\rho$(2K) ($\mu\Omega$cm) | RRR | $\mu$(2K) ($cm^2V^{-1}s^{-1}$) | n(2K) ($x10^{22}cm^{-3}$) |
|---|---|---|---|---|---|---|
| $SrTiO_3$ (0 0 1) | 2 | 6.1 | 0.003 | 2015 | 47290 | 4.36 |
| | 5 | 4.4 | 0.002 | 2082 | 52700 | 5.62 |
| | 7 | 5.0 | 0.002 | 3123 | - | - |
| | 19 | 9.7 | 0.007 | 1463 | 41330 | 2.26 |

(continued)

| Substrate | $SrNbO_3$ Film Thickness (nm) | ρ(300K) (μΩcm) | ρ(2K) (μΩcm) | RRR | μ(2K) ($cm^2V^{-1}s^{-1}$) | n(2K) ($x10^{22}cm^{-3}$) |
|---|---|---|---|---|---|---|
| | 39 | 12.8 | 0.009 | 1430 | 38290 | 1.82 |
| | 61 | 12.6 | 0.012 | 1012 | 32350 | 1.55 |
| | 74 | 11.3 | 0.008 | 1381 | 43400 | 1.75 |
| $SrTiO_3$ (1 1 1) | 23 | 14.6 | 0.007 | 2142 | 48340 | 2.01 |
| LSAT (0 0 1) | 16 | 69.8 | 61.7 | 1.13 | 11.3 | 0.89 |
| $DyScO_3$ (1 1 0) | 70 | 48.9 | 43.0 | 1.38 | * | * |

The transparent conductor's performance is assessed through the Haacke figure of merit, (FOM), $\varphi_{TC} = T^{10}/R_s$, where T is the average transmission in the visible and $R_s$ is the sheet resistance. The optical transmission was measured directly for of $SrNbO_3$ film thicknesses on double-side polished $SrTiO_3$ substrates and the average transmission taken in the visible spectrum range of 400 - 800 nm. The highest achieved FOM for the $SrNbO_3$ and charge transfer system is 0.032 $\Omega^{-1}$, significantly higher than $SrNbO_3$ and other correlated metals without the enhancement of charge transfer (Figure 3B, Table 6).

Table 6: TCM properties and FOM values for $SrNbO_3$ + charge transfer systems with varying film thickness; and for $CaNbO_3$ on STO.

| $SrNbO_3$ Film Thickness (nm) | $R_s$ (Ω/□) | Average Transmission (400 - 800 nm) | FOM ($\Omega^{-1}$) |
|---|---|---|---|
| 2 | 9.9 | 0.82 | 0.014 |
| 7.2 | 6.9 | 0.86 | 0.032 |
| 11.3 | 2.1 | 0.76 | 0.03 |
| 19 | 5.1 | 0.63 | 0.00199 |
| 13 ($CaNbO_3$ on STO) | 3.6 | 0.76 | 0.019 |

Without the charge transfer between the correlated metal and transparent semiconductor, the enhanced transparent conducting properties could not be achieved.

Nb:doped STO has these highly mobile carriers, but at these thicknesses is not conducting enough to reach the desired sheet resistance. We can assume an average Nb dopant of 0.5 across our 3 unit cell interface, as the dopant is graded from 0 in the bulk $SrTiO_3$ to 1 in the bulk $SrNbO_3$ . At 50% dopant, we only have on average around 1E21 carriers. In this regime, for the desired sheet resistance of 10 Ω/□, the film thickness must be over 800 nm and the average T in the visible is 0%. Therefore the diffusion of Nb into the STO cannot create these properties alone.

Figure 4A is a graph of normalised intensity as a function of $2\theta$ for 74 nm SNO on STO; Figure 4B is a graph of intensity as a function of $\omega$ for 74 nm SNO on STO; Figure 4C is a graph of intensity as a function of $2\theta$ for SNO on STO (111); and Figure 4D is a graph of oxidation state as a function of energy for different films. Thick sample (74nm) on STO and thick (80nm) and thin (20nm) samples on DSO ($DyScO_3$ (110)) show oxidation state close to 4+. Thinner (20nm) sample on STO shows slightly increased oxidation state which could be interpreted as a small amount of Nb diffusion into the STO substrate at the interface. Film deposited on other substrate orientation (STO (111)) grows highly crystalline in same condition. Shows the similar low room temperature sheet resistance as films on STO (001).

The diffraction data are for 20nm SNO deposited on $SrTiO_3$ (111) - the films are of slightly higher crystal quality (indicated by the FWHM and peak shape of the rocking curve) than films deposited on STO (100) and importantly the high conductivity effect at room temperature still works when grown in this alternative orientation.

For the oxidation state data, the films on DSO for both thicknesses have an oxidation state of around 4+ which is the expected oxidation state for bulk SNO and it is thought that on DSO this relates to a single layer (i.e. no second or interface layer). On STO substrates (i.e. the third layer), the relatively thicker 80 nm SNO layer (i.e. the first layer) also has an oxidation state around 4+. This likely relates to two layers - the SNO first layer and the second or interface layer - but because the films is thick enough, a bulk oxidation state from the SNO layer is observed. A higher conductivity is observed than would be expected for a single layer of SNO even for the relatively thicker SNO film (80 nm). For the relatively thinner 20 nm SNO film on the STO substrate, a larger proportional effect from the interface layer is observed. This is due to Nb doping into the STO, forming the interface layer - so the oxidation state is a little higher, towards the Nb doped STO

standard sample measured as oxidation state 5+ (top right black square point).

***Experimental***

*Target Preparation and Film growth*

The $SrNbO_3$ films were deposited via pulsed laser deposition on $SrTiO_3$ (001), $DyScO_3$ (110), $LaAlO_3$ (001) and LSAT (001) single crystal substrates with lattice mismatch of -2.96%, -1.84%, -5.79% and -3.88% respectively. Substrates were sonicated in ethanol for cleaning but received no further treatment, retaining the mixed termination from manufacture.

A dense ceramic target of $Sr_2Nb_2O_7$ was prepared via conventional solid-state synthesis as outlined in the literature, with an additional pressing in a cold isostatic press before the final sintering step [Balasubramaniam, Journal of Solid State Chemistry, Volume 181, Issue 4, April 2008, pages 705-714].

The $Nb^{5+}$ oxidation state of the target was reduced to the $Nb^{4+}$ of the film during growth. This was achieved with a reducing growth environment as has been demonstrated in previous reports i.e. pulsed laser deposition in a low chamber base pressure (~$5x10^{-7}$ Torr), with no oxygen flow [Oka 2015]. The substrate was held at 750°C throughout the growth. The laser fluence on the target was 0.74 $J/cm^2$ at a rate of 2Hz with an KrF excimer laser.

*XRD*

The structural quality of the films was assessed with x-ray diffraction techniques using a Rigaku SmartLab diffractometer. A $\theta$ - $2\theta$ scan revealed the out-of-plane phase and crystallographic orientation. Wide reciprocal space mapping with a Hypix 2D detector was used to look for oxidized phases in plane.

*AFM*

AFM images were acquired using a Keysight 5600LS microscope in tapping mode.

*TEM-EDX*

TEM-EDX samples were prepared using focused ion beam (FIB) technique. The film was covered with carbon and platinum protection layers. For the high angle annular dark field scanning transmission electron microscopy (HAADF-STEM) imaging and STEM-EDX analysis, a probe aberration corrected microscope FEI Titian operated at 300 kV and equipped with Super X detector was used.

*XANES*

XANES measurements were taken on the B18 general purpose XAS beamline at Diamond Light Source. The Nb K-edge was measured on standards ($NbO_2$, $Nb_2O_5$, $Sr_2Nb_2O_7$, $La_{1/3}NbO_3$, 0.5 wt.% Nb doped STO) in transmission. The thin film samples and $SrTiO_3$ 0.05 wt% Nb doped single crystal were measured in grazing incidence geometry. Several measurements were taken for each sample and averaged to improve signal to noise ratio. The absorption edges were normalised in Athena data processing software.

*UV-Vis*

A straight through baseline was taken with nothing in the beamline to account for environment effects. A $SrTiO_3$ substrate was annealed in growth conditions and measured to account for silver paste diffusion into the backside of the substrate. This was subtracted to measure the transmission of only the $SrNbO_3$ and charge transfer system without the interference of the substrate.

*Transport*

Transport property measurements were taken in a Quantum Design Physical Properties Measurement System (PPMS) capable of a temperature range of 300K to 2K and applying magnetic fields up to a magnitude of 14T. The films were contacted in Van der Pauw geometry, which consists of four contacts in the corners of the samples.

*Modelling - NextNano*

Modelling of the Poisson solution of the SNO/STO interface was performed using NextNano (RTM) software package. The interface was modelled as 18nm $SrNbO_3$ film with 1.2nm interface thickness based on TEM results showing 3 unit cell interdiffusion of Nb/Ti. 18nm film of $SrNbO_3$ is defined as $SrTi_{1-x}Nb_xO_3$ where x = 1 and constant. Constant doping of $1.535x10^{22}$ $cm^{-3}$ to define carrier density. 1.2 nm interface layer defined as $SrTi_{1-x}Nb_xO_3$ with linear gradation from x = 1 to x = 0. Dopants also defined as a linear gradation from $1.535x10^{22}$ $cm^{-3}$ to $1x10^{16}$ $cm^{-3}$ across the interface thickness. Substrate is $SrTiO_3$ with $1x10^{16}$ $cm^{-3}$ n-type dopant (fully ionised) to account for reduction pre-film deposition.

Although a preferred embodiment has been shown and described, it will be appreciated by those skilled in the art that various changes and modifications might be made without departing from the scope of the invention, as defined in the appended claims.

## Claims

1. A transparent conducting film comprising a set of layers including a first layer, a third layer and a second layer at the interface between the first layer and the third layer

    wherein the first layer is a transparent conductive oxide, TCO, having a formula:

    $$A^1\ B^1\ 0_{3-\delta 1};$$

    wherein the third layer is a transparent wide-bandgap semiconductor oxide having a formula:
    $A^3\ B^3\ 0_{3-\delta 3}$;
    wherein the second layer is an oxide layer having a formula:

    $$A_\alpha^1 A_{1-\alpha}^3 B^1\ O_{3-\delta_2} \text{ or } A_\alpha^1 A_{1-\alpha}^3 B^3\ O_{3-\delta_2} \text{ or } A^3\ B_\beta^1 B_{1-\beta}^3 O_{3-\delta_2} \text{or } A_\alpha^1 A_{1-\alpha}^3 B_\beta^1 B_{1-\beta}^3 O_{3-\delta_2};$$

    wherein 0 < $\alpha$, $\beta$ < *1*, -0.5 ≤ $\delta_1$, $\delta_2$, $\delta_3$ ≤ 0.5;
    **characterized in that** the TCO is $SrNbO_3$ and the transparent wide-bandgap semiconductor is $SrTiO_3$.

2. The film according to claim 1, wherein the first layer has the formula:

    $$A_{1-x}^{1,1} A_x^{1,2} B_{1-y}^{1,1} B_y^{1,2} O_{3-\delta_1} \text{ or } \left(A^{1,1} B^{1,1} O_{3-\delta_{1,1}}\right)_j \left(A^{1,2} B^{1,2} O_{3-\delta_{1,2}}\right)_k;$$

    wherein 0 < *x*, *y* < 1, -0.5 ≤ $\delta_1$ ($\delta_{1,1}$ + $\delta_{1,2}$) ≤ 0.5 and/or 1 ≤ *j*, *k* ≤ 10.

3. The film according to any previous claim, wherein the first layer has a thickness in a range from 2 to 100 nm.

4. The film according to any previous claim, wherein the transparent wide-bandgap semiconductor oxide has the formula:

    $$A_{1-u}^{3,1} A_u^{3,2} B_{1-v}^{3,1} B_v^{3,2} O_{3-\delta_3} \text{ or } \left(A^{3,1} B^{3,1} O_{3-\delta_{3,1}}\right)_m \left(A^{3,2} B^{3,2} O_{3-\delta_{3,2}}\right)_n;$$

    wherein 0 < *u*, *v* < 1, -0.5 ≤ $\delta_3$, ($\delta_{3,1}$ + $\delta_{3,2}$) ≤ 0.5 and/or 1 ≤ *m*, *n* ≤ 10.

5. The film according to any previous claim, wherein the second layer comprises and/or is a compositionally-graded layer, optionally having a linear composition gradient therethrough.

6. The film according to claim 5, wherein the second layer comprises and/or is a compositionally-graded layer having a linear composition gradient therethrough.

7. The film according to any previous claim, wherein the second layer has a thickness in a range from 0.5 to 5 nm.

8. An electrode comprising a transparent conducting film according to any of claims 1 to 7 on a substrate.

**9.** A method of providing a transparent conducting film according to any of claims 1 to 7, comprising:

depositing the first layer on the third layer; and
diffusing at least some of $B^1$ into the third layer, thereby providing the second layer.

**10.** The method according to claim 9, wherein depositing the first layer on the third layer is by pulsed laser deposition.

## Patentansprüche

**1.** Transparenter leitfähiger Film, der einen Satz von Schichten umfasst, der eine erste Schicht, eine dritte Schicht und eine zweite Schicht an der Grenzfläche zwischen der ersten Schicht und der dritten Schicht einschließt,

wobei die erste Schicht ein transparentes leitfähiges Oxid, TCO, mit der folgenden Formel ist:

$$A^1\ B^1\ O_{3-\delta 1};$$

wobei die dritte Schicht ein transparentes Halbleiteroxid mit breiter Bandlücke mit der folgenden Formel ist:

$$A^3\ B^3\ O_{3-\delta 3};$$

wobei die zweite Schicht eine Oxidschicht mit der folgenden Formel ist:

$$A^1_\alpha A^3_{1-\alpha} B^1\ O_{3-\delta_2} \quad \text{oder} \quad A^1_\alpha A^3_{1-\alpha} B^3\ O_{3-\delta_2} \quad \text{oder} \quad A^3\ B^1_\beta B^3_{1-\beta} O_{3-\delta_2} \quad \text{oder}$$

$$A^1_\alpha A^3_{1-\alpha} B^1_\beta B^3_{1-\beta} O_{3-\delta_2};$$

wobei 0 < $\alpha,\beta$ **< 1, -0,5 ≤** $\delta_1,\delta_2,\delta_3$ **≤ 0,5;**
**dadurch gekennzeichnet, dass**:
das TCO $SrNbO_3$ ist, und der transparente Halbleiter mit breiter Bandlücke $SrTiO_3$ ist.

**2.** Film nach Anspruch 1, wobei die erste Schicht die folgende Formel aufweist:

$$A^{1,1}_{1-x} A^{1,2}_x B^{1,1}_{1-y} B^{1,2}_y O_{3-\delta_1} \quad \text{oder} \quad \left(A^{1,1} B^{1,1} O_{3-\delta_{1,1}}\right)_j \left(A^{1,2} B^{1,2} O_{3-\delta_{1,2}}\right)_k;$$

wobei 0 < x,y < 1, $-0,5 \leq \delta_1,(\delta_{1,1} + \delta_{1,2}) \leq 0,5$ und/oder $1 \leq j,k \leq 10$.

**3.** Film nach einem vorhergehenden Anspruch, wobei die erste Schicht eine Dicke in einem Bereich von 2 bis 100 nm aufweist.

**4.** Film nach einem vorhergehenden Anspruch, wobei das transparente Halbleiteroxid mit breiter Bandlücke die folgende Formel aufweist:

$$A^{3,1}_{1-u} A^{3,2}_u B^{3,1}_{1-v} B^{3,2}_v O_{3-\delta_3} \quad \text{oder} \quad \left(A^{3,1} B^{3,1} O_{3-\delta_{3,1}}\right)_m \left(A^{3,2} B^{3,2} O_{3-\delta_{3,2}}\right)_n;$$

wobei **0 < u,v < 1. -0,5 ≤** $\delta_3,(\delta_{3,1} + \delta_{3,2})$ **≤ 0,5** und/oder $1 \leq m, n \leq 10$.

**5.** Film nach einem vorhergehenden Anspruch, wobei die zweite Schicht eine in der Zusammensetzung abgestufte Schicht umfasst und/oder ist, die gegebenenfalls einen linearen Zusammensetzungsgradienten durch sie hindurch aufweist.

**6.** Film nach Anspruch 5, wobei die zweite Schicht eine in der Zusammensetzung abgestufte Schicht mit einem linearen Zusammensetzungsgradienten durch diese umfasst und/oder ist.

7. Film nach einem vorhergehenden Anspruch, wobei die zweite Schicht eine Dicke in einem Bereich von 0,5 bis 5 nm aufweist.

8. Elektrode, umfassend einen transparenten leitfähigen Film nach einem der Ansprüche 1 bis 7 auf einem Substrat.

9. Verfahren zum Bereitstellen eines transparenten leitfähigen Films nach einem der Ansprüche 1 bis 7, umfassend:

Abscheiden der ersten Schicht auf der dritten Schicht; und
Diffundieren mindestens eines Teils von $B^1$ in die dritte Schicht, wodurch die zweite Schicht bereitgestellt wird.

10. Verfahren nach Anspruch 9, wobei Abscheiden der ersten Schicht auf der dritten Schicht durch gepulste Laserabscheidung erfolgt.

## Revendications

1. Film conducteur transparent comprenant un ensemble de couches comprenant une première couche, une troisième couche et une deuxième couche à l'interface entre la première couche et la troisième couche

la première couche étant un oxyde conducteur transparent, TCO, de formule :

$$A^1 B^1 O_{3-\delta 1};$$

la troisième couche étant un oxyde semi-conducteur transparent à large bande interdite ayant une formule :

$$A^3 B^3 O_{3-\delta 3};$$

la deuxième couche étant une couche d'oxyde de formule :

$$A^1_\alpha A^3_{1-\alpha} B^1 O_{3-\delta_2} \text{ ou } A^1_\alpha A^3_{1-\alpha} B^3 O_{3-\delta_2} \text{ ou } A^3 B^1_\beta B^3_{1-\beta} O_{3-\delta_2} \text{ ou } A^1_\alpha A^3_{1-\alpha} B^1_\beta B^3_{1-\beta} O_{3-\delta_2};$$

avec $0 < \alpha,\beta < 1$, $-0,5 \leq \delta_1,\delta_2,\delta_3 \leq 0,5$;
**caractérisé en ce que** :
le TCO est $SrNbO_3$ et le semi-conducteur transparent à large bande interdite est $SrTiO_3$.

2. Film selon la revendication 1, la première couche ayant la formule :

$$A^{1,1}_{1-x} A^{1,2}_x B^{1,1}_{1-y} B^{1,2}_y O_{3-\delta_1} \text{ ou } \left(A^{1,1} B^{1,1} O_{3-\delta_{1,1}}\right)_j \left(A^{1,2} B^{1,2} O_{3-\delta_{1,2}}\right)_k;$$

avec $0 < x,y < 1$, $-0,5 \leq \delta_{1,1} + \delta_{1,2} ) \leq 0,5$ et/ou $1 \leq j,k \leq 10$.

3. Film selon l'une quelconque des revendications précédentes, la première couche ayant une épaisseur dans une plage de 2 à 100 nm.

4. Film selon l'une quelconque des revendications précédentes, l'oxyde semi-conducteur transparent à large bande interdite ayant la formule :

$$A^{3,1}_{1-u} A^{3,2}_u B^{3,1}_{1-v} B^{3,2}_v O_{3-\delta_3} \text{ ou } \left(A^{3,1} B^{3,1} O_{3-\delta_{3,1}}\right)_m \left(A^{3,2} B^{3,2} O_{3-\delta_{3,2}}\right)_n;$$

avec **$0 < u,v < 1$, $-0.5 \leq \delta_3,(\delta_{3,1} + \delta_{3,2}) \leq 0,5$** et/ou $1 \leq m,n \leq 10$.

5. Film selon l'une quelconque des revendications précédentes, la deuxième couche comprenant et/ou étant une couche à gradient de composition, ayant éventuellement un gradient de composition linéaire à travers celle-ci.

6. Film selon la revendication 5, la deuxième couche comprenant et/ou étant une couche à gradient de composition ayant un gradient de composition linéaire à travers celle-ci.

7. Film selon l'une quelconque des revendications précédentes, la deuxième couche ayant une épaisseur dans une plage de 0,5 à 5 nm.

8. Électrode comprenant un film conducteur transparent selon l'une quelconque des revendications 1 à 7 sur un substrat.

9. Procédé de fourniture d'un film conducteur transparent selon l'une quelconque des revendications 1 à 7, comprenant :

   le dépôt de la première couche sur la troisième couche ; et
   la diffusion d'au moins une partie de $B^1$ dans la troisième couche, fournissant ainsi la deuxième couche.

10. Procédé selon la revendication 9, le dépôt de la première couche sur la troisième couche s'effectuant par dépôt laser pulsé.

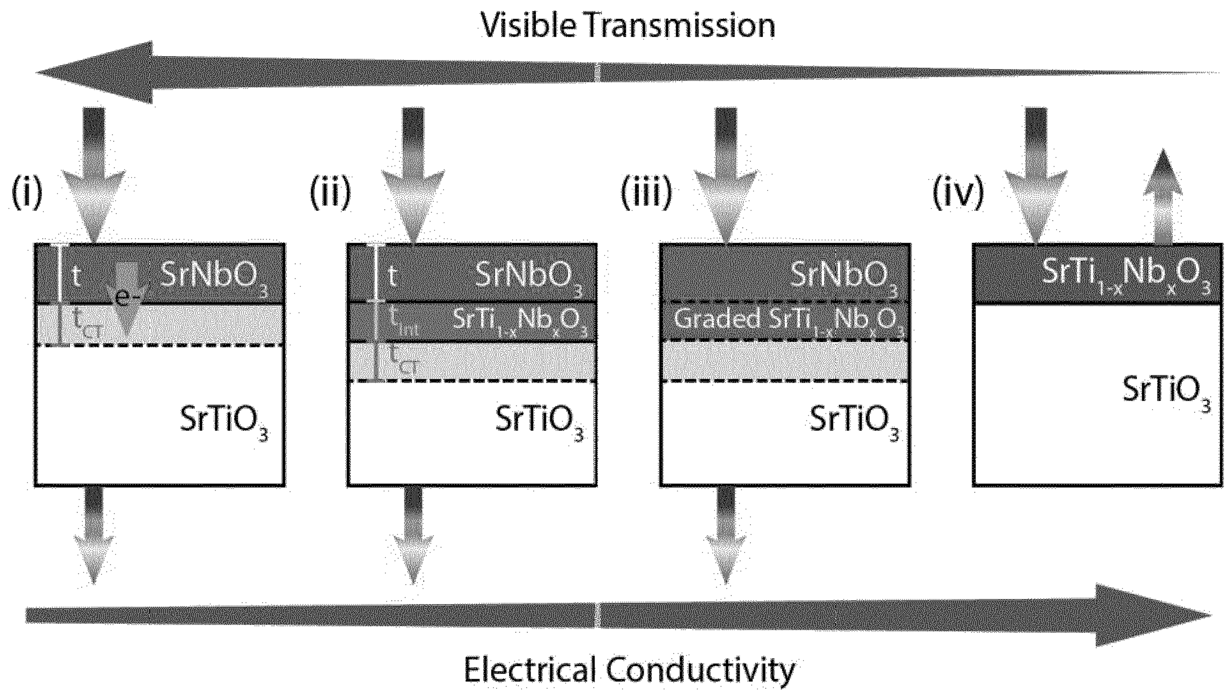
Visible Transmission
(i)
(ii)
(iii)
(iv)
t
SrNbO3
e-
tCT
SrTiO3
t
SrNbO3
tInt
SrTi1-xNbxO3
tCT
SrTiO3
SrNbO3
Graded SrTi1-xNbxO3
SrTiO3
SrTi1-xNbxO3
SrTiO3
Electrical Conductivity

Fig. 1

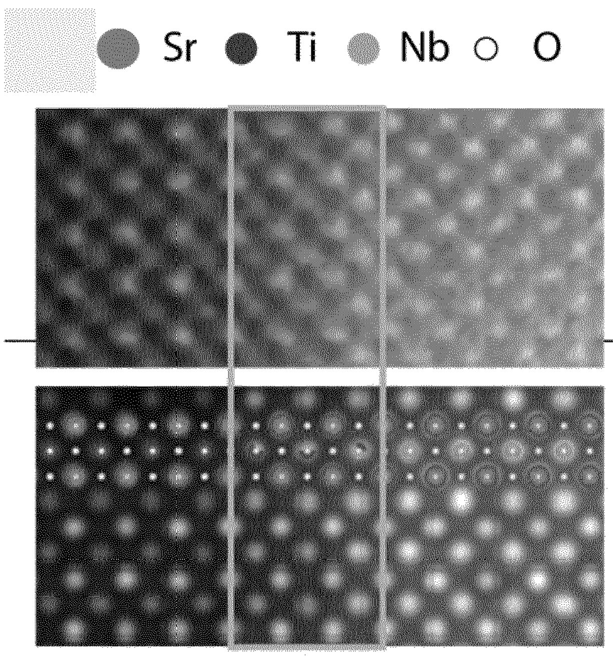


Fig. 2A

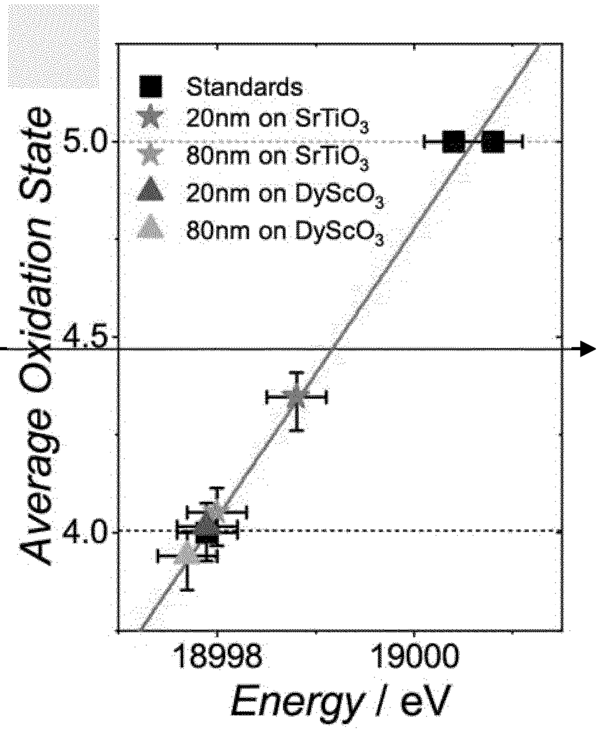


Fig. 2B

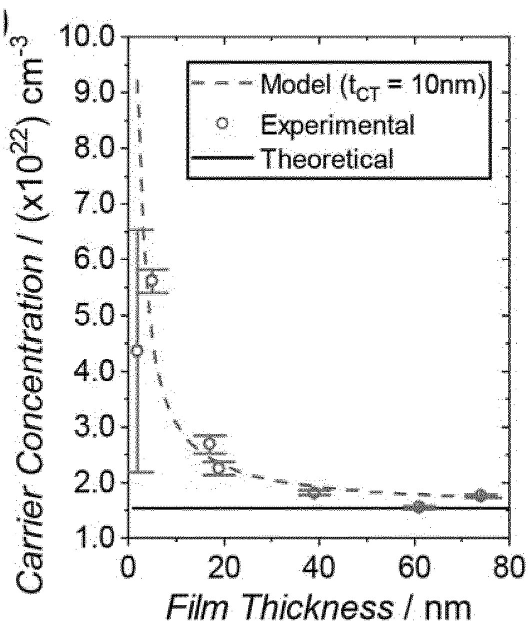


Fig. 2C

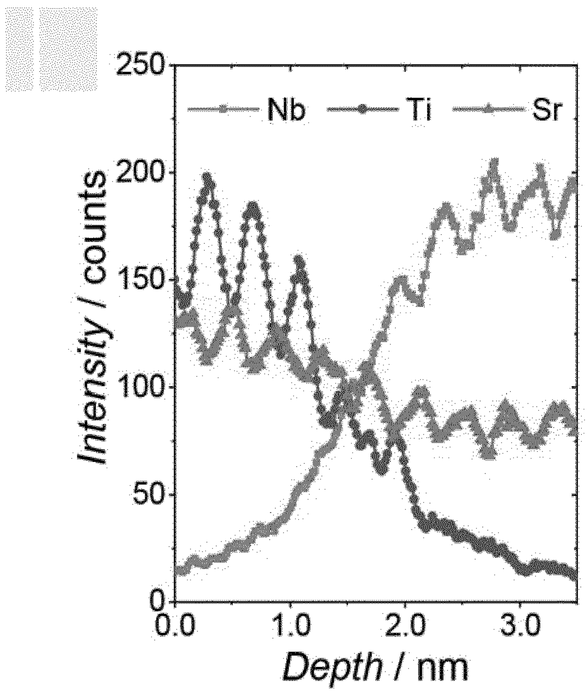


Fig. 2D

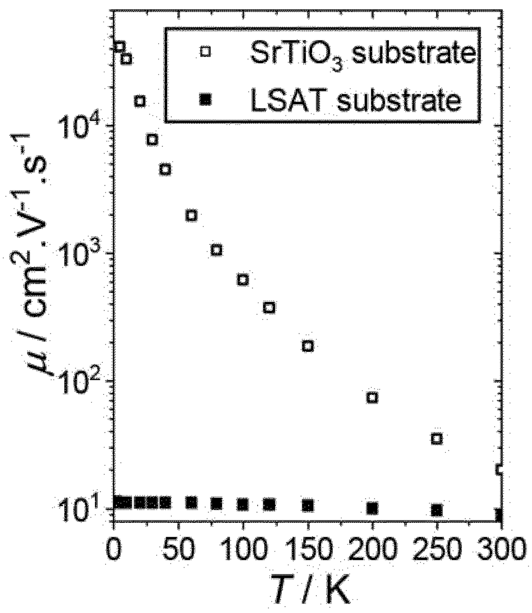
SrTiO3 substrate
LSAT substrate
10^4
10^3
10^2
10^1
μ / cm^2.V^-1.s^-1
0
50
100
150
200
250
300
T / K

Fig. 2E

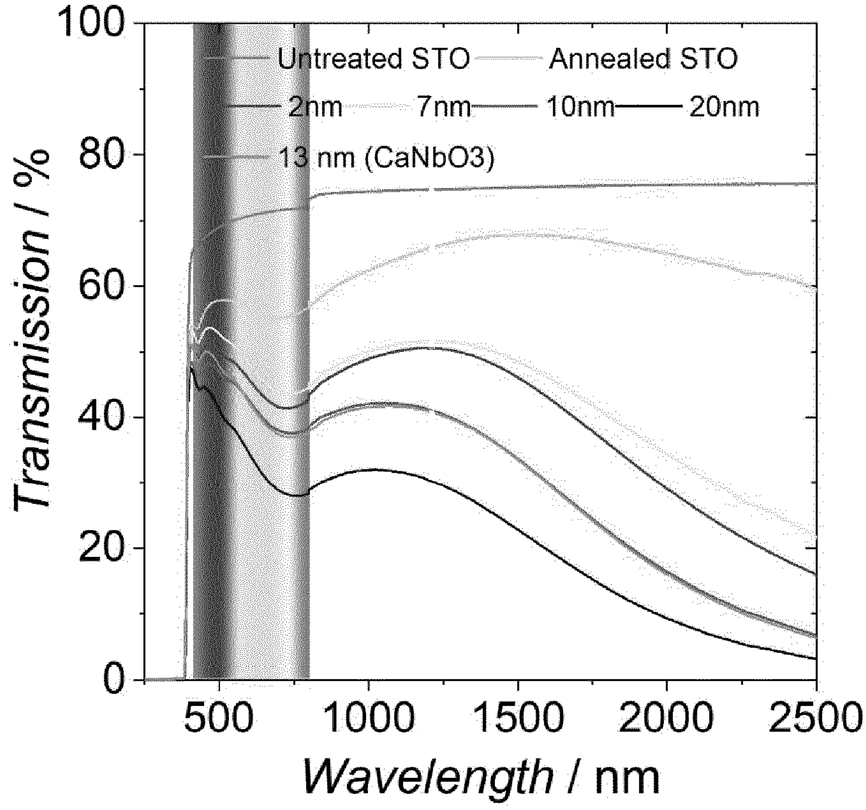

Transmission / %
Wavelength / nm
Untreated STO
Annealed STO
2nm
7nm
10nm
20nm
13 nm (CaNbO3)


Fig. 3A

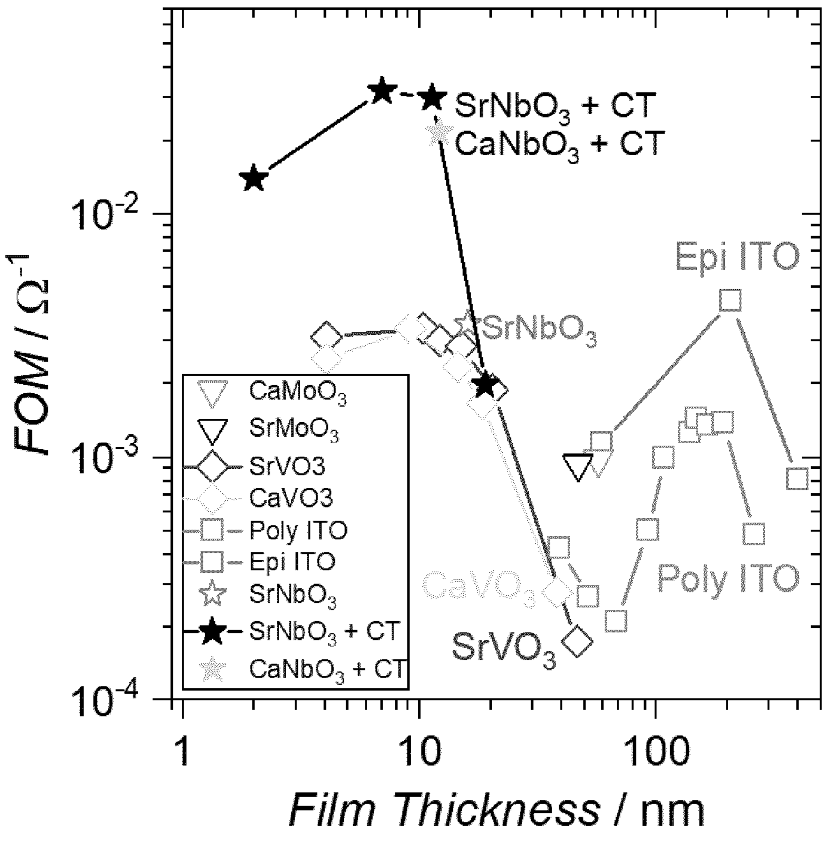

FOM / Ω-1
Film Thickness / nm
SrNbO3 + CT
CaNbO3 + CT
Epi ITO
SrNbO3
CaMoO3
SrMoO3
SrVO3
CaVO3
Poly ITO
Epi ITO
SrNbO3
SrNbO3 + CT
CaNbO3 + CT
CaVO3
Poly ITO
SrVO3


Fig. 3B

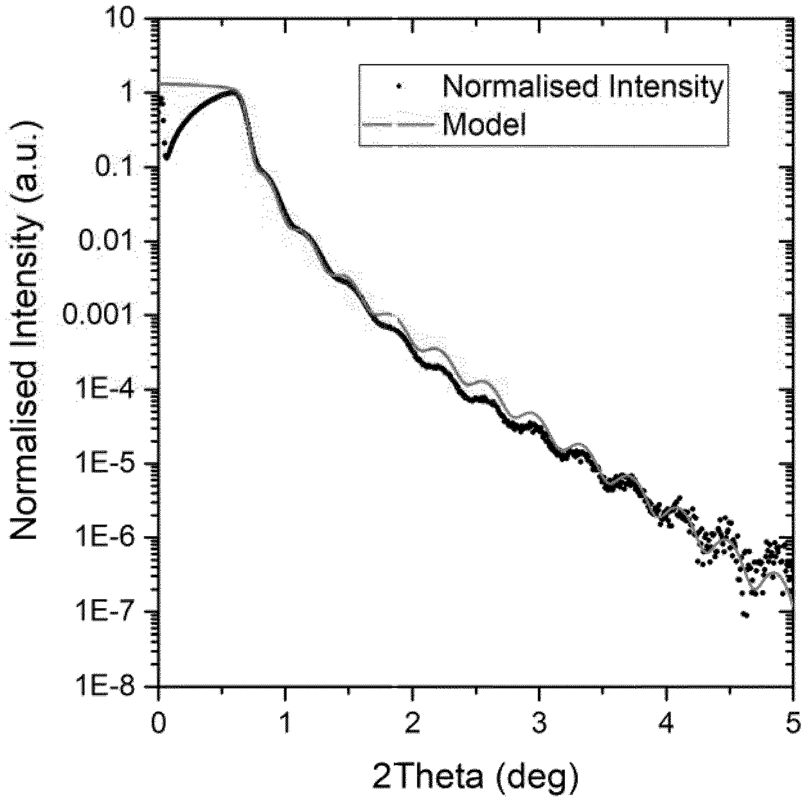
Normalised Intensity
Model
Normalised Intensity (a.u.)
10
1
0.1
0.01
0.001
1E-4
1E-5
1E-6
1E-7
1E-8
0
1
2
3
4
5
2Theta (deg)

**Fig. 4A**

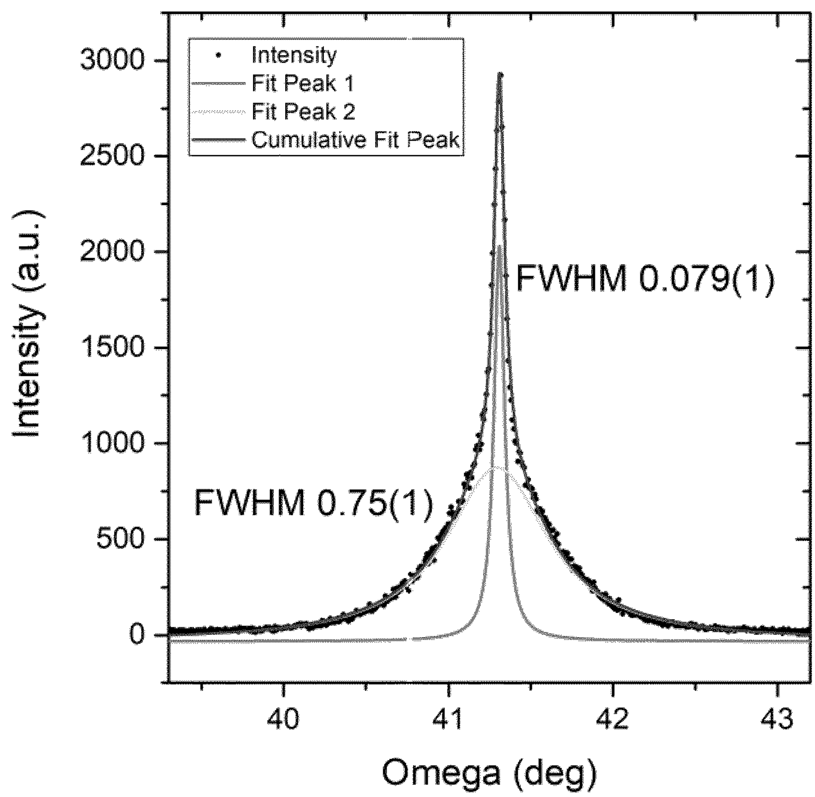
Intensity
Fit Peak 1
Fit Peak 2
Cumulative Fit Peak
FWHM 0.079(1)
FWHM 0.75(1)
Intensity (a.u.)
3000
2500
2000
1500
1000
500
0
40
41
42
43
Omega (deg)

**Fig. 4B**

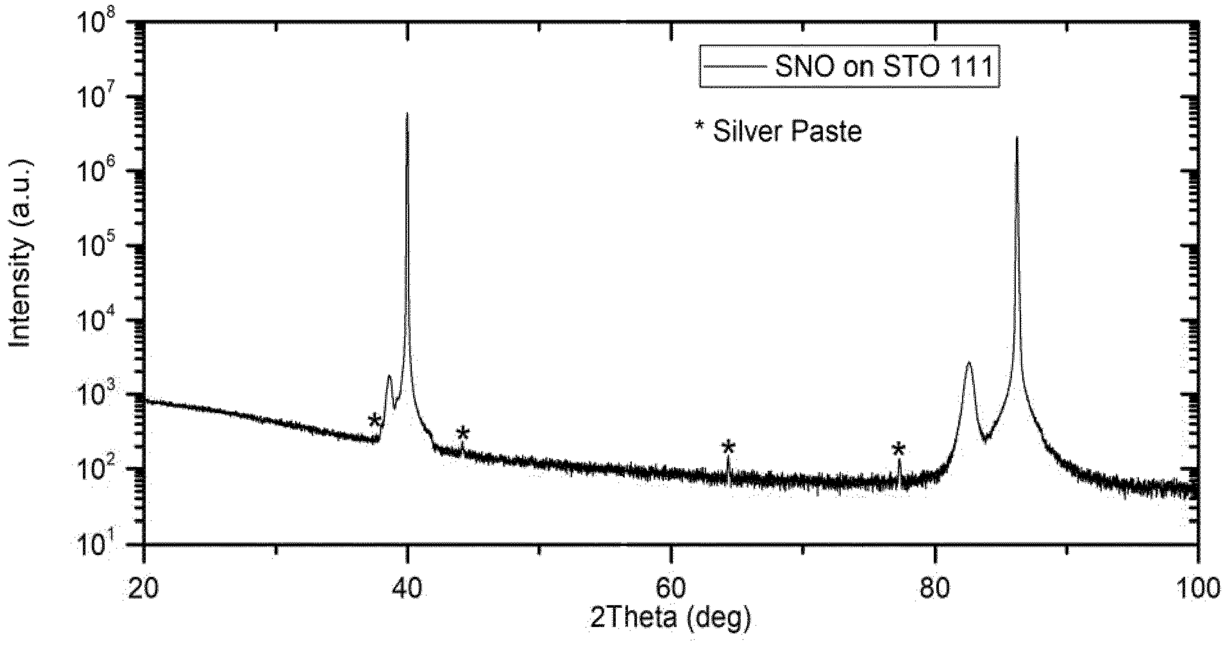

SNO on STO 111
* Silver Paste
Intensity (a.u.)
2Theta (deg)


Fig. 4C

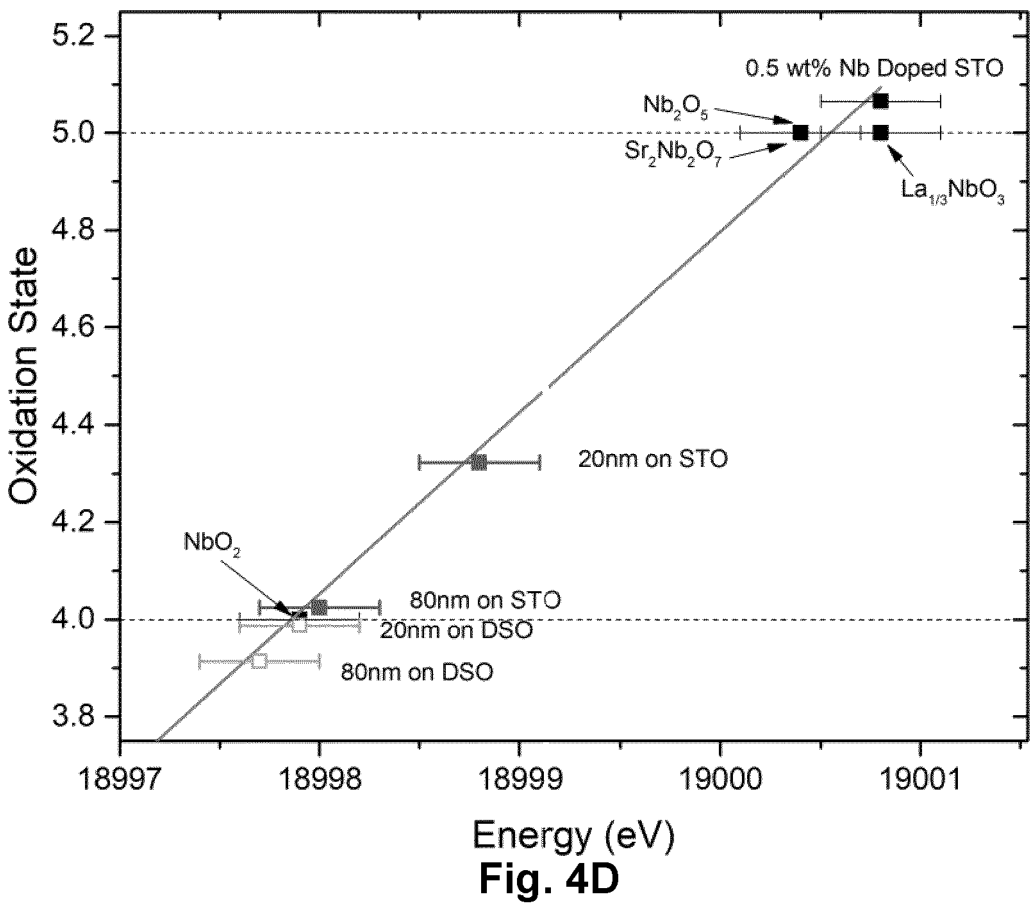

0.5 wt% Nb Doped STO
Nb2O5
Sr2Nb2O7
La1/3NbO3
20nm on STO
NbO2
80nm on STO
20nm on DSO
80nm on DSO
Oxidation State
Energy (eV)


Fig. 4D

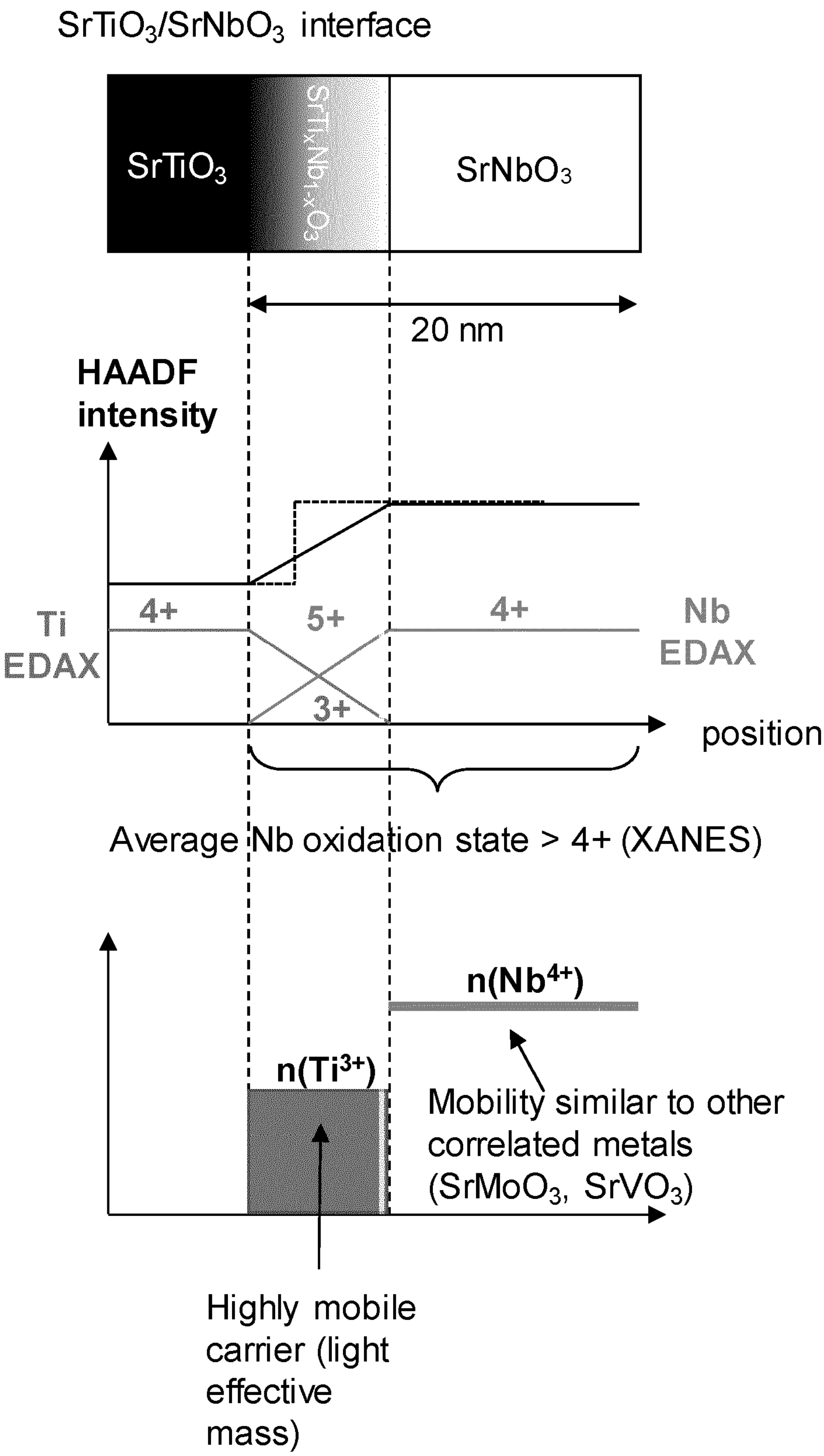
SrTiO3/SrNbO3 interface
SrTiO3
SrTixNb1-xO3
SrNbO3
20 nm
HAADF intensity
Ti EDAX
4+
5+
4+
3+
Nb EDAX
position
Average Nb oxidation state > 4+ (XANES)
n(Nb4+)
n(Ti3+)
Mobility similar to other correlated metals (SrMoO3, SrVO3)
Highly mobile carrier (light effective mass)

Fig. 5

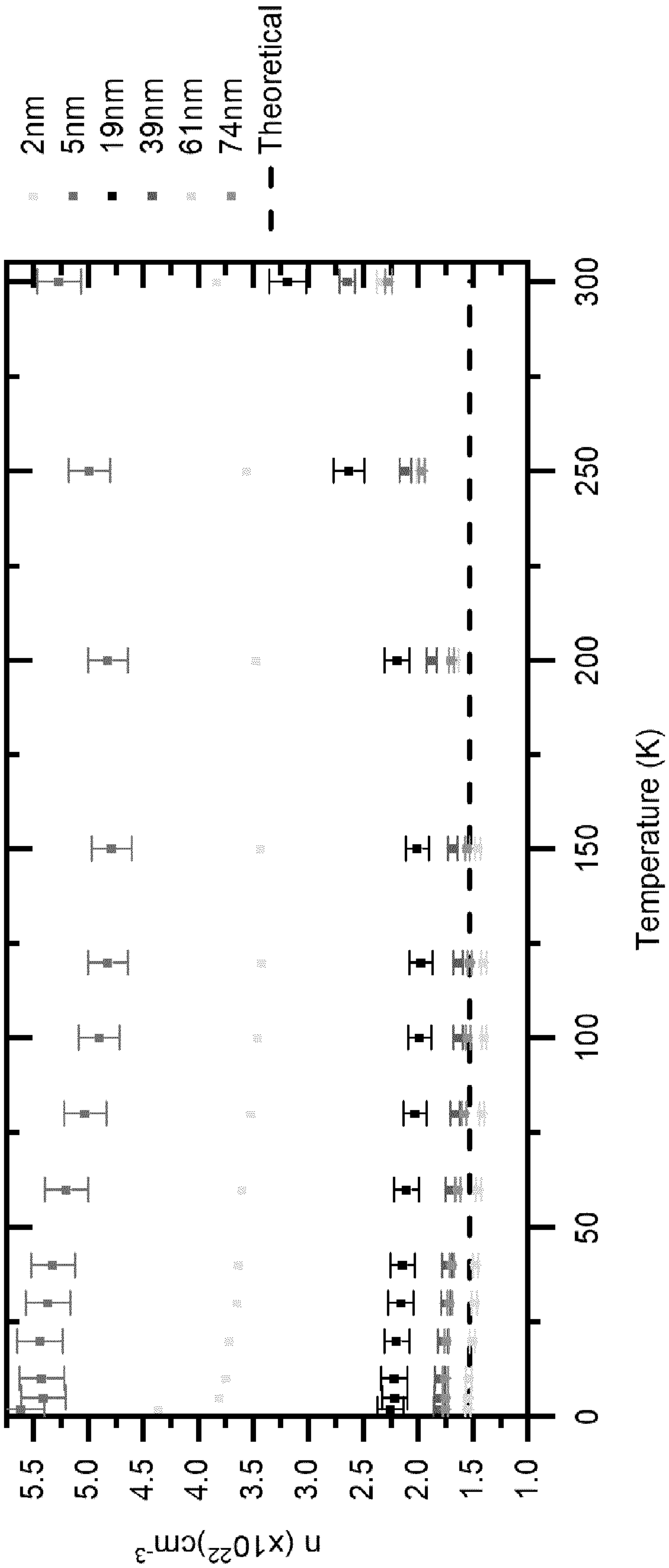
2nm
5nm
19nm
39nm
61nm
74nm
Theoretical
n (x10$^{22}$)cm$^{-3}$
Temperature (K)
0
50
100
150
200
250
300
5.5
5.0
4.5
4.0
3.5
3.0
2.5
2.0
1.5
1.0

Fig. 6

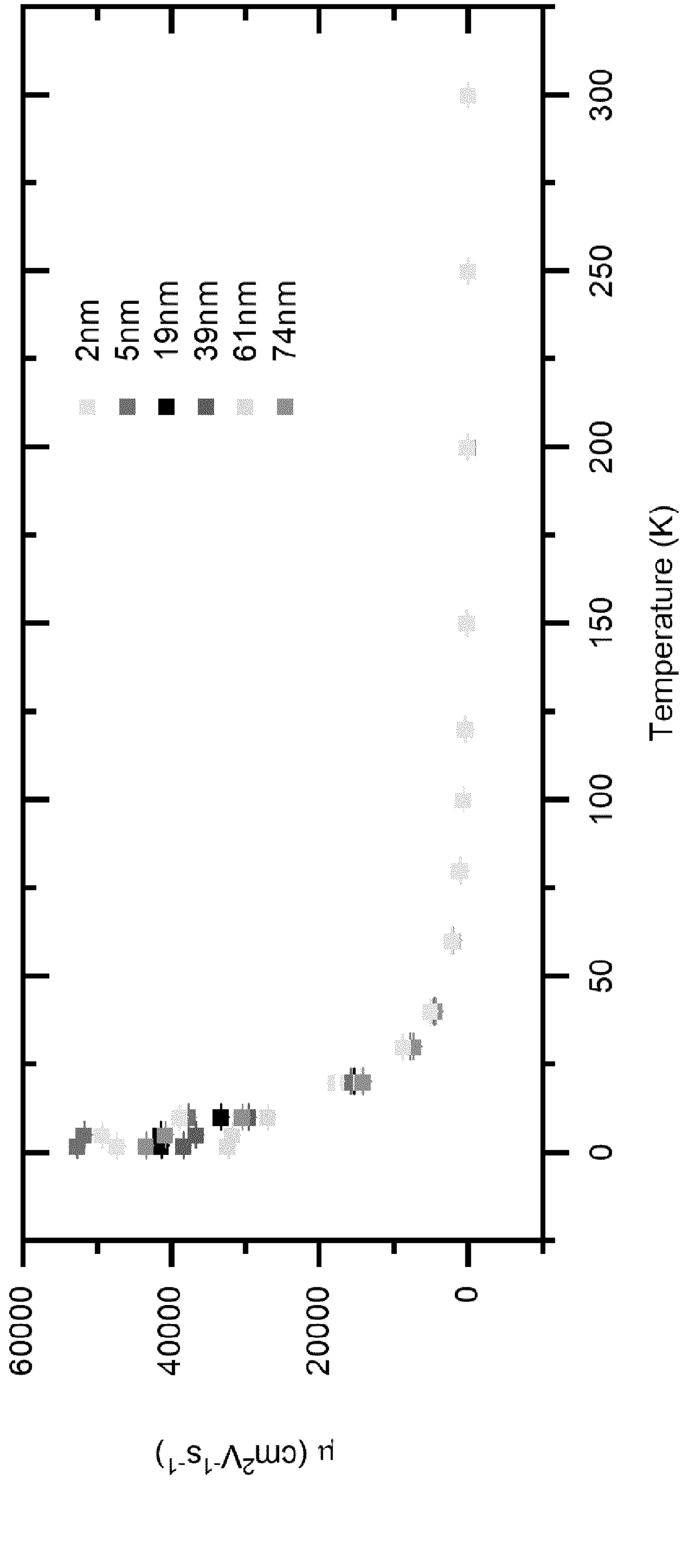
μ (cm$^2$V$^{-1}$s$^{-1}$)
60000
40000
20000
0
Temperature (K)
0
50
100
150
200
250
300
2nm
5nm
19nm
39nm
61nm
74nm

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2016019327 A1

### Non-patent literature cited in the description


- **STONER, JESSICA L. et al.** Chemical Control of Correlated Metals as Transparent Conductors. *ADVANCED FUNCTIONAL MATERIALS*, 25 January 2019, vol. 29 (11), 1808609
- Electronic Localization in CaVO3 Films via Bandwidth Control. **DANIEL E MCNALLY et al.** ARXIV.ORG. CORNELL UNIVERSITY LIBRARY, 28 August 2019
- Order-Disorder Behavior at Thin Film Oxide Interfaces. **STEVEN R SPURGEON**. ARXIV.ORG. CORNELL UNIVERSITY LIBRARY, 30 July 2020
- **ZHICHENG ZHONG** ; **PHILIPP HANSMANN**. Band Alignment and Charge Transfer in Complex Oxide Interfaces. *PHYSICAL REVIEW*, 2017, vol. X 7, 011023
- **Y. TOKURA**. Correlated-Electron Physics in Transition-Metal Oxides. *Physics Today*, 2003, vol. 56, 50, https://doi.org/10.1063/1.1603080
- **ABHINAV PRAKASH** ; **BHARAT JALAN**. Wide Bandgap Perovskite Oxides with High Room-Temperature Electron Mobility. *Advanced Material Interfaces*, 06 July 2019, vol. 6, 1900479, https://doi.org/10.1002/admi.201900479
- **OKA**. *Phys. Rev. B*, 2015, vol. 92, 205102
- **BALASUBRAMANIAM**. *Journal of Solid State Chemistry*, April 2008, vol. 181 (4), 705-714